# EUROPÄISCHE PATENTSCHRIFT

(11) **EP 2 080 031 B1**
(45) Veröffentlichungstag und Bekanntmachung des Hinweises auf die Patenterteilung: **02.06.2010**
(21) Anmeldenummer: 07817707.8
(22) Anmeldetag: 22.10.2007
(51) Int. Cl.: G01R 31/3193

(54) **VERFAHREN ZUM ÜBERWACHEN, OB DIE SCHALTSCHWELLE EINES SCHALTGEBERS INNERHALB EINES VORGEGEBENEN TOLERANZBEREICHS LIEGT**
METHOD FOR MONITORING WHETHER THE SWITCHING THRESHOLD OF A SWITCHING SENSOR LIES WITHIN A PREDEFINED TOLERANCE REGION
PROCÉDÉ POUR VÉRIFIER SI LE SEUIL DE COMMUTATION D'UN GÉNÉRATEUR DE COMMUTATION SE SITUE DANS UNE PLAGE DE TOLÉRANCE PRÉDÉFINIE

(30) Priorität: 20.10.2006 DE 102006050399; 28.10.2006 DE 102006051312
(43) Veröffentlichungstag der Anmeldung: 22.07.2009
(73) Patentinhaber: Pepperl + Fuchs GmbH, 68307 Mannheim (DE)
(72) Erfinder: HOFMAYER, Matthias, 67354 Römersberg (DE); KINDERMANN, Michael, 38114 Braunschweig (DE)
(74) Vertreter: Mierswa, Klaus
(86) Internationale Anmeldenummer: PCT/DE2007/001873
(87) Internationale Veröffentlichungsnummer: WO 2008/046415

(56) Entgegenhaltungen:
- WO-A-03/046590
- US-A1- 2005 189 950

## Beschreibung

### Technisches Gebiet:

Die Erfindung betrifft ein Verfahren zum Überwachen, ob die Schaltschwelle eines Schaltgebers, insbesondere eines Komparators, innerhalb eines vorgegebenen Toleranzbereichs liegt oder nicht.

### Stand der Technik:

In unzähligen Anwendungen erfolgen Schaltvorgänge in Abhängigkeit von Messwerten bzw. Signalgrößen. Beispielsweise kann es - um nur einige wenige von zahllosen Anwendungen exemplarisch anzuführen - zum Zweck der Zweipunktregelung einer Temperatur, zur Überwachung des Innendrucks in einem Druckbehälter, zur Begrenzung des Stromes in einem Kabel, zum helligkeitsabhängigen Ein- und Ausschalten von Straßenlampen, zum Auslösen von Rauchmeldern und Sprinkleranlagen bei Feuer, zum Betreiben von Antikollisions-Näherungssensoren, zum Betreiben eines Antiblockiersystems oder einer Bremsbelag-Verschleißanzeige in einem Kraftfahrzeug oder zum automatischen Abschalten eines industriellen Roboters bei Annäherung eines Menschen erforderlich sein, dass ein Schaltvorgang ausgelöst wird, wenn ein Messwert oder sonstiges Signal einen vorgegebenen Schwellwert übersteigt oder unterschreitet. Der Schwellwert gibt somit eine Schaltschwelle vor.

Bereits diese Beispiele zeigen, dass Fehlfunktionen bei derartigen Schaltvorgängen nicht nur einen Funktionsablauf stören können, sondern erhebliche Sachwerte und insbesondere auch die Sicherheit von Menschen gefährden können.

Fehlfunktionen können bei derartigen Schaltvorgängen insbesondere dadurch verursacht werden, dass der Schwellwert sich unbemerkt von einem Sollwert entfernt, d.h. unkontrolliert driftet. Eine solche Schaltschwellendrift kann z.B. die Folge von Temperaturschwankungen, Alterung, Verschmutzung, Verschleiß oder Produktionsfehlern von Bauteilen sein; bei computer- oder Mikroprozessorgesteuerten Systemen kommen auch Softwarefehler und Programmabstürze als mögliche Ursache in Betracht.

Durch die US 2005/189950 A1 ist ein Verfahren zum Kalkulieren und Testen der Schaltschwelle eines Komparators mittels zweier Dreiecksignale am Komparatoreingang bekannt geworden. Hierzu weisen die beiden Dreiecksignale die gleiche Periode aber unterschiedliche Amplituden auf, wobei ein Ausgangssignal des Komparators mit einer berechenbaren Schaltschwelle erhalten wird. Eine periodische Wellenform kann ebenso mittels dreieckförmigen sich wiederholenden Wellenformsegmenten erzeugt werden, welche die gleiche Periode und unterschiedliche Amplituden als Eingang in den Komparator aufweisen.

Durch die WO03/046590 ist eine Testvorrichtung für integrierte Schaltkreise bekannt geworden. Wird zum Testen ein integrierter Schaltkreis in die Testvorrichtung eingeführt, so wird eine externe Rückkopplungsschleife zwischen einem Eingang und einem Ausgang eines Komparators innerhalb eines integrierten Testvorrichtungsschaltkreises errichtet. Daraufhin oszilliert eine Eingangsspannung des Komparators um eine Schaltschwelle des Komparators. Das Testergebnis ist vom durchschnittlichen Wert der oszillierenden Spannung innerhalb der Rückkopplungsschleife abhängig. Die Rückkopplungsschleife kann mit einem digitalen Tester mit einem zusätzlichen analogen integrierten Schaltkreis, welcher dem Ausgang hinzugefügt ist, realisiert werden.

### Technische Aufgabe:

Der Erfindung liegt die Aufgabe zu Grunde, ein Verfahren bereitzustellen, mit welchem überwacht werden kann, ob sich die Schaltschwelle eines Schaltgebers innerhalb eines Toleranzbereichs befindet, wobei das Verfahren insbesondere anwendbar sein soll zur Überwachung eines elektrischen Signals auf Drift sowie dazu, bei Schaltvorgängen der genannten Art die Schaltschwelle auf Drift zu überwachen, insbesondere bei Schaltvorgängen unter Verwendung von Bauteilen, bei denen die Drift elektrischer Parameter nicht ausgeschlossen werden kann oder darf, und bei Schaltgeräten das Risiko von unentdeckten Ausfällen zu reduzieren.

Diese Aufgabe wird erfindungsgemäß gelöst durch ein Verfahren zum Überwachen, ob die Schaltschwelle eines Schaltgebers, insbesondere eines Komparators, innerhalb eines vorgegebenen Toleranzbereichs liegt oder nicht, wobei der Schaltgeber
- einen Signaleingang, an welchem ein Eingangssignal anliegt, sowie einen Schaltausgang aufweist
- und über den Schaltausgang ein Schaltausgangssignal abgibt, welches einen ersten Wert annimmt, falls das Eingangssignal größer ist als die Schaltschwelle, und andernfalls einen zweiten Wert annimmt,
**dadurch gekennzeichnet, dass**
a) als Eingangssignal ein von einem Modulator erzeugtes Modulatorsignal verwendet wird, welches sich fortlaufend oder zyklisch ändert zwischen einem Ausgangswert, welcher die obere Grenze des Toleranzbereichs vorgibt, und einem Testwert, welcher kleiner ist als der Ausgangswert und die untere Grenze des Toleranzbereichs vorgibt,
   so dass das Schaltausgangssignal dann im Takt des Modulatorsignals zwischen dem ersten und dem zweiten Wert pulsiert, wenn die Schaltschwelle des Schaltgebers im Toleranzbereich liegt, und andernfalls nicht pulsiert,
b) und das Schaltausgangssignal mittels einer Auswerteeinrichtung auf Pulsation überwacht und ein Alarmsignal ausgelöst wird, wenn das Schaltausgangssignal für mindestens eine vorgegebene Prüfzeitspanne nicht pulsiert.

In vorteilhafter Weise stellt die Erfindung ein Verfahren zur Verfügung, mit welchem überwacht werden kann, ob sich die Schaltschwelle eines Schaltgebers innerhalb eines Toleranzbereichs befindet. Hierbei ist das Verfahren insbesondere anwendbar zur Überwachung eines elektrischen Signals auf Drift sowie dazu, dass bei Schaltvorgängen der genannten Art die Schaltschwelle auf Drift zu überwacht werden kann, insbesondere bei Schaltvorgängen unter Verwendung von Bauteilen, bei denen die Drift elektrischer Parameter nicht ausgeschlossen werden kann oder darf. Ebenso wird bei Schaltgeräten das Risiko von unentdeckten Ausfällen reduziert.

Die Prüfzeitspanne ist bevorzugt länger als die maximale Pulslänge des Schaltausgangssignals, d.h. länger als die maximale Dauer, für welche das Schaltausgangssignal ununterbrochen den ersten Wert annimmt, und auch länger als die maximale Dauer, für welche das Schaltausgangssignal ununterbrochen den zweiten Wert annimmt. Diese beiden dauern brauchen nicht notwendigerweise gleich lang zu sein. Die Pulsation des Modulatorsignals kann periodisch oder aperiodisch sein.

Der Schaltgeber ist ein elektrischer Schaltgeber, welcher imstande ist, auf ein elektrisches Signal anzusprechen und hierdurch einen Schaltvorgang zu vollziehen. Mit der Schaltschwelle ist die elektrische Schaltschwelle des elektrischen Schaltgebers gemeint.

Die Prüfzeitspanne ist vorzugsweise x-mal so lang gewählt wie die maximale Pulslänge des Schaltausgangssignals, wobei x eine Zahl größer als 1 ist. Beispielsweise kann x eine Zahl zwischen 2 und 10 sein.

Das Alarmsignal zeigt also an, dass die Schaltschwelle außerhalb des Toleranzbereichs liegt bzw. mindestens während der Prüfzeitspanne außerhalb des Toleranzbereichs gelegen hat.

Eine Schaltung zur Überwachung der Schaltschwelle eines Schaltgebers auf Abweichung von einem Sollwert umfasst eine Auswerteeinrichtung und einen Modulator, wobei
A) der Schaltgeber wenigstens einen Signaleingang und einen Schaltausgang aufweist,
B) der Modulator wenigstens zeitweise ein Modulatorsignal an den Signaleingang des Schaltgebers abgibt, welches sich fortlaufend oder zyklisch ändert zwischen einem Ausgangswert, welcher größer ist als der Sollwert, und einem Testwert, welcher kleiner ist als der Sollwert,
C) der Schaltgeber über den Schaltausgang ein Schaltausgangssignal abgibt, welches einen ersten Wert annimmt, falls das Modulatorsignal größer ist als die Schaltschwelle, und andernfalls einen zweiten Wert annimmt,
   so dass das Schaltausgangssignal dann im Takt des Modulatorsignals zwischen dem
   ersten und dem zweiten Wert pulsiert, wenn die Schaltschwelle des Schaltgebers zwischen dem Ausgangswert und dem Testwert liegt und somit um höchstens eine vorgegebene Toleranz vom Sollwert abweicht, und andernfalls nicht pulsiert,
D) die Auswerteeinrichtung das Schaltausgangssignal auf Pulsation überwacht und ein Alarmsignal auslöst, wenn das Schaltausgangssignal für mindestens eine vorgegebene Prüfzeitspanne nicht pulsiert.

Die Erfindung betrifft gemäß einer Variante ein Verfahren zur Überwachung der Schaltschwelle eines Schaltgebers auf Abweichung von einem Sollwert, unter Verwendung einer Auswerteeinrichtung und eines Modulators, wobei der Schaltgeber wenigstens einen Signaleingang und einen Schaltausgang aufweist, mit folgenden Schritten:
a) mittels des Modulators wird wenigstens zeitweise ein Modulatorsignal erzeugt, welches sich fortlaufend oder zyklisch ändert zwischen einem Ausgangswert, welcher größer ist als der Sollwert, und einem Testwert, welcher kleiner ist als der Sollwert,
b) mit dem Modulatorsignal wird über den Signaleingang der Schaltgeber angesteuert,
c) mittels des Schaltgebers wird ein Schaltausgangssignal erzeugt und über den Schaltausgang abgegeben, welches einen ersten Wert annimmt, falls das Modulatorsignal größer ist als die Schaltschwelle, und andernfalls einen zweiten Wert annimmt, so dass das Schaltausgangssignal dann im Takt des Modulatorsignals zwischen dem ersten und dem zweiten Wert pulsiert, wenn die Schaltschwelle des Schaltgebers zwischen dem Ausgangswert und dem Testwert liegt und somit um höchstens eine vorgegebene Toleranz vom Sollwert abweicht, und andernfalls nicht pulsiert,
d) mit dem Schaltausgangssignal wird die Auswerteeinrichtung angesteuert,
e) mittels der Auswerteeinrichtung wird das Schaltausgangssignal auf Pulsation überwacht und ein Alarmsignal ausgelöst, wenn das Schaltausgangssignal für mindestens eine vorgegebene Prüfzeitspanne nicht pulsiert.

Eine Schaltung zur Überwachung eines elektrischen Signals, z.B. eines Fremdsignals, auf Abweichung von einem Sollwert, umfasst eine Auswerteeinrichtung, einen Modulator und einen Schaltgeber mit vorgegebener Schaltschwelle, wobei
AA) der Schaltgeber wenigstens einen Signaleingang und einen Schaltausgang aufweist,
BB) entweder die Schaltschwelle kleiner ist als der Sollwert und der Modulator wenigstens zeitweise ein Modulatorsignals an den Signaleingang des Schaltgebers abgibt, welches sich fortlaufend oder zyklisch ändert zwischen einem Ausgangswert, welcher wenigstens zu einem Anfangszeitpunkt gleich dem Sollwert und größer als die Schaltschwelle ist, und einem Testwert, welcher wenigstens zum Anfangszeitpunkt kleiner ist als die Schaltschwelle, so dass der Ausgangswert und der Testwert die Grenzen eines Toleranzbereichs bilden, innerhalb welchem die Schaltschwelle zumindest zum Anfangszeitpunkt liegt,
BB') oder die Schaltschwelle größer ist als der Sollwert und der Modulator wenigstens zeitweise ein Modulatorsignal an den Signaleingang des Schaltgebers abgibt, welches sich fortlaufend oder zyklisch ändert zwischen einem Ausgangswert, welcher wenigstens zu einem Anfangszeitpunkt größer als die Schaltschwelle, und einem Testwert, welcher wenigstens zum Anfangszeitpunkt gleich dem Sollwert und kleiner als die Schaltschwelle ist, so dass der Ausgangswert und der Testwert die Grenzen eines Toleranzbereichs bilden, innerhalb welchem die Schaltschwelle zumindest zum Anfangszeitpunkt liegt,
CC) der Schaltgeber ein Ausgangssignal abgibt, welches einen ersten Wert annimmt, falls das Modulatorsignal größer ist als die Schaltschwelle, und andernfalls einen zweiten Wert annimmt,
   so dass das Ausgangssignal dann im Takt des Modulatorsignals zwischen dem ersten und dem zweiten Wert pulsiert, wenn die Schaltschwelle im Toleranzbereich liegt und somit das elektrische Signal um höchstens eine vorgegebene Toleranz vom Sollwert abweicht, und das Ausgangssignal andernfalls nicht pulsiert,
DD) die Auswerteeinrichtung das Ausgangssignal auf Pulsation überwacht und ein Alarmsignal auslöst, wenn das Ausgangssignal für mindestens eine vorgegebene Prüfzeitspanne nicht pulsiert, und somit das Alarmsignal anzeigt, dass der Toleranzbereich die Schaltschwelle nicht mehr einschließt und somit das elektrische Signal um mehr als die vorgegebene Toleranz vom Sollwert abweicht.

Die Erfindung betrifft gemäß einer weiteren Variante ein Verfahren zur Überwachung eines elektrischen Signals auf Abweichung von einem Sollwert, unter Verwendung einer Auswerteeinrichtung, eines Modulators und eines Schaltgebers mit vorgegebener Schaltschwelle, wobei
aa) der Schaltgeber wenigstens einen Signaleingang und einen Schaltausgang aufweist,
bb) entweder die Schaltschwelle kleiner ist als der Sollwert und der Modulator wenigstens zeitweise ein Modulatorsignal an den Signaleingang des Schaltgebers abgibt, welches sich fortlaufend oder zyklisch ändert zwischen einem Ausgangswert, welcher wenigstens zu einem Anfangszeitpunkt gleich dem Sollwert und größer als die Schaltschwelle ist, und einem Testwert, welcher wenigstens zum Anfangszeitpunkt kleiner ist als die Schaltschwelle, so dass der Ausgangswert und der Testwert die Grenzen eines Toleranzbereichs bilden, innerhalb welchem die Schaltschwelle zumindest zum Anfangszeitpunkt liegt,
bb') oder die Schaltschwelle größer ist als der Sollwert und der Modulator wenigstens zeitweise ein Modulatorsignal an den Signaleingang des Schaltgebers abgibt, welches sich fortlaufend oder zyklisch ändert zwischen einem Ausgangswert, welcher wenigstens zu einem Anfangszeitpunkt größer als die Schaltschwelle, und einem Testwert, welcher wenigstens zum Anfangszeitpunkt gleich dem Sollwert und kleiner als die Schaltschwelle ist, so dass der Ausgangswert und der Testwert die Grenzen eines Toleranzbereichs bilden, innerhalb welchem die Schaltschwelle zumindest zum Anfangszeitpunkt liegt,
cc) mittels des Schaltgebers ein Ausgangssignal erzeugt und abgegeben wird, welches einen ersten Wert annimmt, falls das Modulatorsignal größer ist als die Schaltschwelle, und andernfalls einen zweiten Wert annimmt,
   so dass das Ausgangssignal dann im Takt des Modulatorsignals zwischen dem ersten und dem zweiten Wert pulsiert, wenn die Schaltschwelle im Toleranzbereich liegt und somit das elektrische Signal um höchstens eine vorgegebene Toleranz vom Sollwert abweicht, und das Ausgangssignal andernfalls nicht pulsiert,
dd) das Ausgangssignal mittels der Auswerteeinrichtung auf Pulsation überwacht wird und ein Alarmsignal ausgelöst wird, wenn das Ausgangssignal für mindestens eine vorgegebene Prüfzeitspanne nicht pulsiert, und somit das Alarmsignal anzeigt, dass der Toleranzbereich die Schaltschwelle nicht mehr einschließt und somit das elektrische Signal um mehr als die vorgegebene Toleranz vom Sollwert abweicht.

Der Modulator fungiert somit als Pulsgeber bzw. Pulsgenerator. Mit dem Schaltgeber ist ein Bauelement oder eine Schaltung gemeint, welche einen Schaltvorgang ausführt, sobald ein an das Bauelement bzw. die Schaltung angelegtes Signal eine Schaltschwelle übersteigt bzw. unterschreitet. Der Schaltgeber kann z.B. ein Komparator, ein Optokoppler, ein Transistor, ein Thyristor oder ein Differenzverstärker sein. Die Pulsationsfrequenz des Modulatorsigals kann z.B. 1kHz betragen. Die Auswerteeinheit kann z.B. ein Mikroprozessor sein.

Der Ausgangswert ist die obere, der Testwert die untere Grenze des Toleranzbereichs. Der Toleranzbereich ist somit der Bereich, in welchem die Schaltschwelle liegen kann, ohne dass das Alarmsignal ausgelöst wird. Wenn die Schaltschwelle nicht im Toleranzbereich liegt, wird das Alarmsignal ausgelöst. Die Schaltschwelle kann den Toleranzbereich dadurch verlassen, dass sie über eine seiner beiden Grenzen hinausdriftet, oder dadurch, dass sich umgekehrt der Toleranzbereich so ändert, dass die Schaltschwelle nicht mehr in ihm liegt. Der erstgenannte Fall eignet sich insbesondere zur Überwachung der Schaltschwelle auf Drift, der zweitgenannte Fall zur Überwachung eines beliebigen elektrischen Signals auf Drift, sofern der Toleranzbereich der Drift des Signals nachgeführt wird.

Das erfindungsgemäße Verfahren kann sowohl zur Überwachung der Schaltschwelle auf Drift als auch zur Überwachung der Grenzen des Toleranzbereichs auf Drift dienen. Gemäß einer Variante des Verfahrens wird der Toleranzbereich bzw. werden die Grenzen des Toleranzbereichs einem elektrischen Signal bzw. einem Fremdsignal nachgeführt und hierdurch das elektrische Signal bzw. das Fremdsignal auf Drift überwacht.

Die Schaltung kann imstande sein, den Toleranzbereich der Drift des zu überwachenden elektrischen Signals nachzuführen und das Alarmsignal auszulösen, wenn der Toleranzbereich die Schaltschwelle nicht einschließt. Gemäß einer Variante des erfindungsgemäßen Verfahrens befindet sich daher die Schaltschwelle zu einem Anfangszeitpunkt innerhalb des Toleranzbereichs, wobei der Toleranzbereich der Drift des zu überwachenden elektrischen Signals nachgeführt und das Alarmsignal ausgelöst wird, wenn der Toleranzbereich die Schaltschwelle nicht mehr einschließt. Vorzugsweise ist die obere oder die untere Grenze des Toleranzbereichs gleich dem zu überwachenden Signal bzw. dem zu überwachenden Fremdsignal. Gemäß einer anderen Variante ist das zu überwachende Signal größer als der Ausgangswert; gemäß einer weiteren Variante ist das zu überwachende Signal kleiner als der Testwert; gemäß einer weiteren Variante ist das zu überwachende Signal größer als der Testwert, aber kleiner als der Ausgangswert.

Gemäß einer bevorzugten Variante werden der Ausgangswert und der Testwert jeweils konstant oder jeweils im zeitlichen Mittel konstant gehalten, so dass das Alarmsignal eine Drift der Schaltschwelle nach außerhalb des Toleranzbereichs anzeigt. Gemäß dieser Variante wird somit die Schaltschwelle auf Drift überwacht.

Gemäß einer bevorzugten Variante ist der Schaltgeber ein Komparator mit einem Referenzeingang, wobei die Schaltschwelle durch eine am Referenzeingang anliegende Referenzspannung vorgegeben wird, so dass eine Drift der Referenzspannung eine Drift der Schaltschwelle nach sich zieht und daher das Alarmsignal eine Drift der Referenzspannung um mehr als einen bestimmten Toleranzbetrag anzeigt. Gemäß dieser Variante wird somit die Referenzspannung auf Drift überwacht.

Bevorzugt wird für die Schaltschwelle ein Sollwert vorgegeben wird, welcher kleiner ist als der Ausgangswert und größer ist als der Testwert, so dass das Alarmsignal anzeigt, dass die Schaltschwelle um mehr als einen bestimmten Betrag vom Sollwert abweicht bzw. zumindest während der Prüfzeitspanne um mehr als einen bestimmten Betrag vom Sollwert abgewichen ist.

Gemäß einer anderen sehr vorteilhaften Variante des erfindungsgemäßen Verfahrens wird die Schaltschwelle konstant oder im zeitlichen Mittel konstant gehalten, wobei der Modulator einen Eingang aufweist, an welchem ein Fremdsignal anliegt und bei Ansteigen des Fremdsignals wenigstens der Testwert und damit die untere Grenze des Toleranzbereichs angehoben wird, so dass spätestens dann, wenn das Fremdsignal um mehr als einen bestimmten Betrag angestiegen ist, die Schaltschwelle unterhalb des Toleranzbereichs liegt und somit das Alarmsignal ausgelöst wird. Gemäß dieser Variante wird somit überwacht, ob das Fremdsignal um den bestimmten Betrag angestiegen ist oder nicht.

Hierbei können das Fremdsignal und der Testwert miteinander identisch sein. Gemäß einer anderen Variante wird der Testwert so aus dem Fremdsignal abgeleitet, dass bei Zunahme des Fremdsignals auch der Testwert zunimmt und bei Abnahme des Fremdsignals auch der Testwert abnimmt.

Gemäß einer Variante wird die Schaltschwelle konstant oder im zeitlichen Mittel konstant gehalten, wobei der Modulator einen Eingang aufweist, an welchem ein Fremdsignal anliegt und bei Abfallen des Fremdsignals wenigstens der Ausgangswert und damit die obere Grenze des Toleranzbereichs abgesenkt wird, so dass spätestens dann, wenn das Fremdsignal um mehr als einen bestimmten Betrag abgefallen ist, die Schaltschwelle oberhalb des Toleranzbereichs liegt und somit das Alarmsignal ausgelöst wird. Gemäß dieser Variante wird somit überwacht, ob das Fremdsignal um den bestimmten Betrag abgefallen ist oder nicht.

Hierbei können das Fremdsignal und der Ausgangswert miteinander identisch sein. Gemäß einer anderen Variante wird der Ausgangswert so aus dem Fremdsignal abgeleitet, dass bei Zunahme des Fremdsignals auch der Ausgangswert zunimmt und bei Abnahme des Fremdsignals auch der Ausgangswert abnimmt

Die Grenzen des Toleranzbereichs können somit dem Fremdsignal bzw. dessen Änderungen nachgeführt werden, wobei vorzugsweise der Abstand jeder der Grenzen zu dem Fremdsignal konstant bleibt; sobald hierbei die Änderung des Fremdsignals einen bestimmten Betrag übersteigt, liegt also die Schaltschwelle nicht mehr im Toleranzbereich. Im Ergebnis wird somit erfindungsgemäß das Fremdsignal auf Drift überwacht.

Gemäß einer Variante wird für das Fremdsignal ein Fremdsignal-Sollwert vorgegeben, welcher größer ist als die Schaltschwelle, wobei
- entweder der Ausgangswert wenigstens zu einem Anfangszeitpunkt gleich dem Fremdsignal-Sollwert und größer als die Schaltschwelle ist, und der Testwert wenigstens zum Anfangszeitpunkt kleiner ist als die Schaltschwelle,
- oder der Testwert wenigstens zu einem Anfangszeitpunkt gleich dem Fremdsignal-Sollwert und kleiner als die Schaltschwelle ist, und der Ausgangswert wenigstens zum Anfangszeitpunkt größer ist als die Schaltschwelle,
so dass Schaltschwelle zumindest zum Anfangszeitpunkt innerhalb des Toleranzbereichs liegt, und das Alarmsignal ausgelöst wird, wenn die Schaltschwelle nicht mehr innerhalb des Toleranzbereichs liegt und somit das Fremdsignal um mehr als eine vorgegebene Toleranz vom Fremdsignal-Sollwert abweicht, bzw. wenn die Schaltschwelle für wenigstens die Prüfzeitspanne nicht mehr innerhalb des Toleranzbereichs gelegen hat und somit das Fremdsignal für wenigstens die Prüfzeitspanne um mehr als eine vorgegebene Toleranz vom Fremdsignal-Sollwert abgewichen ist.

Bevorzugt ist die Abfolge der Pulse des Schaltausgangssignals schnell im Vergleich zu der Geschwindigkeit, welche für Änderungen der Schaltschwelle bzw. des Fremdsignals zu erwarten oder möglich sind. Solche Änderungen der Schaltschwelle bzw. des Fremdsignals sind in der Regel nicht gewünscht, jedoch kann das Verfahren hierauf vorteifhafterweise reagieren, falls solche Änderungen auftreten. Bevorzugt liegt die Zahl der Pulse des Modulatorsignals und damit auch die Zahl der Pulse des Schaltausgangssignals zwischen mindestens 1 Puls pro Minute und 100.000 Pulsen pro Sekunde oder 1.000.000 Pulse pro Sekunde, besonders bevorzugt zwischen 200 und 1000 Pulsen pro Sekunde. Die Prüfzeitdauer kann z.B. zwischen 10⁻⁵ Sekunden und 10 Minuten betragen; sie liegt bevorzugt zwischen 0,01 und 0,1 Sekunden, besonders bevorzugt zwischen 0,04 und 0,06 Sekunden. Andere Zahlenwerte sind selbstverständlich möglich.

Bevorzugt ist die Differenz zwischen dem Ausgangswert und dem Testwert zeitlich konstant oder im zeitlichen Mittel konstant. Gemäß einer bevorzugten Verfahrensvariante wird die Differenz zwischen dem Ausgangswert und dem Testwert zeitlich konstant oder im zeitlichen Mittel konstant gehalten.

Gemäß einer anderen Variante ist der Quotient aus dem Ausgangswert und dem Testwert zeitlich konstant oder im zeitlichen Mittel konstant. Gemäß einer Verfahrensvariante wird der Quotient aus dem Ausgangswert und dem Testwert zeitlich konstant oder im zeitlichen Mittel konstant gehalten.

Gemäß einer weiteren bevorzugten Variante ist die Differenz zwischen dem Ausgangswert und dem Testwert auf einen vorgegebenen Maximalwert begrenzt. Gemäß einer Verfahrensvariante wird die Differenz zwischen dem Ausgangswert und dem Testwert auf einen vorgegebenen Maximalwert begrenzt.

Das elektrische Signal bzw. das Fremdsignal kann ein Stromsignal oder ein Spannungssignal sein.

Gemäß einer Variante ist
- entweder der Sollwert ein vorgegebener positiver Soll-Spannungswert, das Modulatorsignal ein positives Spannungssignal, der Ausgangswert ein positiver Ausgangs-Spannungswert, welcher größer ist als der Soll-Spannungswert, und der Testwert ein positiver Test-Spannungswert ist, welcher kleiner ist als der Soll-Spannungswert,
- oder der Sollwert ein vorgegebener negativer Soll-Spannungswert, das Modulatorsignal ein negatives Spannungssignal, der Ausgangswert ein negativer Ausgangs-Spannungswert, welcher betragsmäßig größer ist als der Soll-Spannungswert, und der Testwert ein negativer Test-Spannungswert, welcher betragsmäßig kleiner ist als der Soll-Spannungswert,
wobei die Schaltschwelle jeweils eine Spannungsschaltschwelle ist, so dass das Schaltausgangssignal den ersten Wert annimmt, falls die Spannung des Modulatorsignals größer ist als die Spannungsschaltschwelle, und andernfalls den zweiten Wert annimmt.

Gemäß einer anderen Variante ist
- entweder der Sollwert ein vorgegebener positiver Soll-Stromwert, das Modulatorsignal ein positives Stromsignal, der Ausgangswert ein positiver Ausgangs-Stromwert, welcher größer ist als der Soll-Stromwert, und der Testwert ein positiver Test-Stromwert, welcher kleiner ist als der Soll-Stromwert,
- oder der Sollwert ein vorgegebener negativer Soll-Stromwert, das Modulatorsignal ein negatives Stromsignal, der Ausgangswert ein negativer Ausgangs-Stromwert, welcher betragsmäßig größer ist als der Soll-Stromwert, und der Testwert ein negativer Test-Stromwert, welcher betragsmäßig kleiner ist als der Soll-Stromwert,
wobei die Schaltschwelle jeweils eine Stromschaltschwelle ist, so dass das Schaltausgangssignal den ersten Wert annimmt, falls der Strom des Modulatorsignals größer ist als die Stromschaltschwelle, und andernfalls den zweiten Wert annimmt. Der zweite Wert kann kleiner oder größer sein als der erste Wert.

Der Schaltgeber kann z.B. ein Optokoppler oder ein Transistor oder ein elektronischer Schalter oder ein Differenzverstärker sein. Alle diese Unterarten eines Schaltgebers benötigen, sofern sie intakt sind, bauartbedingt eine bestimmte Mindestspannung bzw. einen bestimmten Mindeststrom als Eingangssignal, um durchzuschalten. Gemäß einer Ausführungsform ist der Schaltgeber ein Komparator mit einem Referenzeingang, an welchem zur Vorgabe der Schaltschwelle eine Referenzspannung anliegt.

Die Schaltung überwacht somit gemäß einer Ausführungsform die Schaltschwelle des Komparators auf Abweichung von dem Sollwert. Da diese Schaltschwelle durch die Referenzspannung gegeben ist, wird auf diese Weise mit der Schaltschwelle auch die Referenzspannung erfindungsgemäß überwacht. Die Schaltung ist somit zugleich auch eine Schaltung zur Überwachung einer Spannung, hier der Referenzspannung, auf Drift. Da Stromsignale ohne weiteres in Spannungssignale umsetzbar sind, z.B. durch Abgreifen des durch den Stromfluss bedingten Spannungsabfalls an einem Widerstand. kann die Schaltung auch zur Überwachung eines Stromsignals auf Drift herangezogen werden.

Als Schaltgeber können z.B. ein Optokoppler oder ein Transistor oder ein elektronischer Schalter oder ein Differenzverstärker verwendet werden. Ferner kann als Schaltgeber z.B. ein Komparator mit einem Referenzeingang verwendet werden, an welchen zur Vorgabe der Schaltschwelle eine Referenzspannung angelegt wird.

Vorrichtungsmäßig kann der Schaltgeber z.B. ein Optokoppler oder ein Transistor oder ein elektronischer Schalter oder ein Differenzverstärker sein. Ferner kann der Schaltgeber z.B. ein Komparator mit einem Referenzeingang sein, an welchem zur Vorgabe der Schaltschwelle eine Referenzspannung anliegt.

Gemäß einer Ausführungsform weist die Schaltung eine Signalquelle auf, welche dem Modulator vorgeschaltet ist und wenigstens zeitweise entweder, Fall (i), ein Quellensignal an den Modulator abgibt, welches größer ist als der Sollwert, oder, Fall (ii), ein Quellensignal an den Modulator abgibt, welches kleiner ist als der Sollwert, wobei der Modulator nur dann, wenn er das Quellensignal von der Signalquelle erhält, das Modulatorsignal an den Signaleingang des Schaltgebers abgibt.

Das Pulsieren des Schaltausgangssignals zeigt in diesem Fall an, dass das Quellensignal momentan größer ist als die Schaltschwelle, und zugleich auch, dass die Schaltschwelle zwischen dem Ausgangswert und dem Testwert liegt.

Im Fall (ii) kann das Quellensignal insbesondere ein Nullsignal sein, d.h. ein solches, dessen Strom- bzw. Spannungswert gleich Null ist.

Die Signalquelle kann insbesondere ein Signalgeber oder ein Sensor sein, welcher entweder im Fall (i) im betätigten Zustand das Quellensignal, welches größer ist als der Sollwert, und im unbetätigten Zustand ein den Sollwert nicht übersteigendes Ruhesignal an den Modulator abgibt, oder im Fall (ii) im betätigten Zustand das Quellensignal, welches kleiner ist als der Sollwert, und im unbetätigten Zustand ein den Sollwert nicht unterschreitendes Ruhesignal an den Modulator abgibt. Im Fall (i) kann das Ruhesignal insbesondere ein Nullsignal sein.

Alternativ hierzu kann die Signalquelle ein Signalgeber oder ein Sensor sein, welcher entweder im Fall (i) im unbetätigten Zustand das Quellensignal, welches größer ist als der Sollwert, und im betätigten Zustand ein den Sollwert nicht übersteigendes Ruhesignal an den Modulator abgibt, oder im Fall (ii) im unbetätigten Zustand das Quellensignal, welches kleiner ist als der Sollwert, und im betätigten Zustand ein den Sollwert nicht unterschreitendes Ruhesignal an den Modulator abgibt.

Gemäß einer Verfahrensvariante wird eine Signalquelle verwendet, welche dem Modulator vorgeschaltet ist und wenigstens zeitweise entweder, Fall (i), ein Quellensignal an den Modulator abgibt, welches größer ist als der Sollwert, oder, Fall (ii), ein Quellensignal an den Modulator abgibt, welches kleiner ist als der Sollwert, wobei das Modulatorsignal vom Modulator nur dann an den Signaleingang des Schaltgebers abgegeben wird, wenn der Modulator das Quellensignal von der Signalquelle erhält.

Als Signalquelle kann ein Signalgeber oder ein Sensor verwendet werden, welcher sich in einem betätigten oder in einem unbetätigten Zustand befinden kann und entweder im Fall (i) im betätigten Zustand das Quellensignal, welches größer ist als der Sollwert, und im unbetätigten Zustand ein den Sollwert nicht übersteigendes Ruhesignal an den Modulator abgibt, oder im Fall (ii) im betätigten Zustand das Quellensignal, welches kleiner ist als der Sollwert, und im unbetätigten Zustand ein den Sollwert nicht unterschreitendes Ruhesignal an den Modulator abgibt.

Alternativ hierzu kann als Signalquelle ein Signalgeber oder ein Sensor verwendet werden, welcher sich in einem betätigten oder in einem unbetätigten Zustand befinden kann und entweder im Fall (i) im unbetätigten Zustand das Quellensignal, welches größer ist als der Sollwert, und im betätigten Zustand ein den Sollwert nicht übersteigendes Ruhesignal an den Modulator abgibt, oder im Fall (ii) im unbetätigten Zustand das Quellensignal, welches kleiner ist als der Sollwert, und im betätigten Zustand ein den Sollwert nicht unterschreitendes Ruhesignal an den Modulator abgibt.

In der Praxis ist der Signalquelle in vielen Fällen standardmäßig ein derartiger Schaltgeber nachgeschaltet, welcher einen Schaltvorgang ausführt, sobald ein an ihn angelegtes Signal eine Schaltschwelle übersteigt bzw. unterschreitet. Beispielsweise kann die Signalquelle ein Sensor mit Schaltausgang und somit das Quellensignal das von diesem gelieferte Schaltsignal sein. Durch den Schaltgeber kann das Quellensignal in ein solches Schaltausgangssignal umgesetzt werden, welches bestimmte vorgegebene Eigenschaften aufweist. Diese Eigenschaften können sich z.B. auf den Maximalwert, den Minimalwert und das zeitliche Verhalten des Schaltausgangssignals beziehen und z.B. in einer Norm oder aus Gründen der Kompatibilität in einer so genannten Schnittstellendefinition festgelegt sein. Die Schnittstellendefinition kann z.B. auch vorsehen, dass das Modulatorsignal ein Stromsignal zu sein hat.

Die Erfindung kann insbesondere sehr vorteilhaft zur Überwachung der Schaltschwelle eines solchen bereits vorhandenen Schaltgebers eingesetzt werden. In der Schnittstellendefinition kann z.B. gefordert sein, dass der Testwert betragsmäßig größer sein muss als der maximale Betrag des Ruhesignals. Die Schnittstellen-definition kann ferner vorgeben, innerhalb welches Wertebereiches das Ruhesignal zu liegen hat.

Dem Modulator kann eine Signalquelle vorgeschaltet sein, welche ein Quellensignal an den Modulator abgibt, welches gleich dem Ausgangswert oder zu diesem proportional ist, oder welches gleich dem Testwert oder zu diesem proportional ist.

Es kann eine Signalquelle verwendet werden, weiche dem Modulator vorgeschaltet ist und ein Quellensignal an den Modulator abgibt, welches gleich dem Ausgangswert oder zu diesem proportional ist, oder welches gleich dem Testwert oder zu diesem proportional ist.

Gemäß einer Ausführungsform der Schaltung ist der Modulator imstande, das Modulatorsignal dadurch zu erzeugen, dass er das Quellensignal
- entweder in fortlaufender oder zyklischer zeitlicher Abfolge nacheinander oder abwechselnd unverändert an den Signaleingang des Schaltgebers abgibt, so dass der Ausgangswert durch das unveränderte Quellensignal gegeben ist, und abgeschwächt an den Signaleingang des Schaltgebers abgibt, so dass der Testwert durch das abgeschwächte Quellensignal gegeben ist,
- oder in fortlaufender oder zyklischer zeitlicher Abfolge nacheinander oder abwechselnd auf einen ersten Bruchteil abgeschwächt an den Signaleingang des Schaltgebers abgibt, so dass der Ausgangswert durch das auf den ersten Bruchteil verringerte Quellensignal gegeben ist, und auf einen zweiten Bruchteil abgeschwächt an den Signaleingang des Schaltgebers abgibt, so dass der Testwert durch das auf den zweiten Bruchteil abgeschwächte Quellensignal gegeben ist, wobei der erste Bruchteil größer ist als der zweite Bruchteil.

Verfahrensmäßig kann das Modulatorsignal dadurch erzeugt werden, dass vom Modulator das Quellensignal
- entweder in fortlaufender oder zyklischer zeitlicher Abfolge nacheinander oder abwechselnd unverändert an den Signaleingang des Schaltgebers abgegeben wird, so dass der Ausgangswert durch das unveränderte Quellensignal gegeben ist, und abgeschwächt an den Signaleingang des Schaltgebers abgegeben wird, so dass der Testwert durch das abgeschwächte Quellensignal gegeben ist,
- oder in fortlaufender oder zyklischer zeitlicher Abfolge nacheinander oder abwechselnd auf einen ersten Bruchteil abgeschwächt an den Signaleingang des Schaltgebers abgegeben wird, so dass der Ausgangswert durch das auf den ersten Bruchteil verringerte Quellensignal gegeben ist, und auf einen zweiten Bruchteil abgeschwächt an den Signaleingang des Schaltgebers abgegeben wird, so dass der Testwert durch das auf den zweiten Bruchteil abgeschwächte Quellensignal gegeben ist, wobei der erste Bruchteil größer ist als der zweite Bruchteil.

Gemäß einer vorteilhaften Ausführungsform weist die Schaltung einen Spannungsbegrenzer auf, welcher das Quellensignal zeitweise auf den Testwert abschwächt und hierdurch den Testwert erzeugt. Gemäß einer anderen vorteilhaften Ausführungsform weist die Schaltung einen Strombegrenzer auf, welcher das Quellensignal zeitweise auf den Testwert abschwächt und hierdurch den Testwert erzeugt.

Das Quellensignal kann mittels eines Begrenzers, insbesondere mittels eines Spannungsbegrenzers oder mittels eines Strombegrenzers, zeitweise auf den Testwert abgeschwächt und hierdurch der Testwert erzeugt werden. Der Spannungsbegrenzer kann z.B. eine Konstantspannungsquelle sein. Ebenso kann der Strombegrenzer eine Konstantstromquelle sein. Der Spannungsbegrenzer bzw. der Strombegrenzer können insbesondere passive Bauteile oder passive Schaltungsanordnungen sein, welche keine eigene Strom- oder Spannungsversorgung benötigen. Ebenso können der Spannungsbegrenzer bzw. der Strombegrenzer Bauteile oder Schaltungsanordnungen sein, welche allein durch das Quellensignal mit Strom- oder Spannung versorgt werden und daher keine separaten Versorgungsleitungen benötigen. Das Quellensignal kann zur Stromversorgung des Modulators dienen, so dass dieser keine separaten Anschlüsse zu seiner Stromversorgung benötigt. Somit kann der Modulator durch das Quellensignal mit elektrischer Energie versorgt werden.

Die Auswerteeinrichtung ist so eingerichtet, dass sie das Alarmsignal auch dann auslöst, oder dass sie ein Meldesignal auslöst, wenn sich die Signalquelle im unbetätigten Zustand befindet und die Schaltschwelle kleiner ist als das Ruhesignal. Alternativ hierzu kann die Auswerteeinrichtung so eingerichtet sein, dass sie das Alarmsignal auch dann auslöst, oder dass sie ein Meldesignal auslöst, wenn sich die Signalquelle im unbetätigten Zustand befindet und die Schaltschwelle größer ist als das Ruhesignal. Somit kann, insbesondere im Fall (i), das Alarmsignal auch dann ausgelöst werden, oder ein Meldesignal auslöst werden, wenn sich die Signalquelle im unbetätigten Zustand befindet und die Schaltschwelle kleiner ist als das Ruhesignal. Gemäß einer anderen Variante wird, insbesondere im Fall (ii), das Alarmsignal auch dann ausgelöst, oder ein Meldesignal ausgelöst, wenn sich die Signalquelle im unbetätigten Zustand befindet und die Schaltschwelle größer ist als das Ruhesignal.

Gemäß einer Variante wird bei unbetätigter Signalquelle bzw. bei unbetätigtem Sensor die Auslösung des Alarmsignals bzw. des Meldesignals unterbunden. Dies kann beispielsweise dadurch erfolgen, dass bei unbetätigter Signalquelle bzw. bei unbetätigtem Sensor die Tätigkeit der Auswerteschaltung blockiert oder das Alarmsignal bzw. das Meldesignal unterdrückt wird. Gemäß einer alternativen Variante wird bei betätigter Signalquelle bzw. bei betätigtem Sensor die Auslösung des Alarmsignals bzw. des Meldesignals unterbunden.

Das Alarmsignal und/oder das Meldesignal können z.B. auf einen Bus, insbesondere in bitcodierter Form bzw. als Datenworte, ggf. in Kombination mit einer Kennung, z.B. auf einen Bus, z.B. Feldbus oder Interface-Bus, aufgegeben werden und von dort zu ihrer Auswertung oder Weiterleitung in andere an den Bus angeschlossene Bausteine eingelesen werden. Die Kennung kann insbesondere die Signalquelle oder den Modulator oder den Schaltgeber angeben, z.B. zur Unterscheidung von anderen Bauteilen derselben Art. Die Signalquelle und/oder der Modulator und/oder der Schaltgeber können Teil eines an den Bus angeschlossenen Slaves sein; in diesem Fall kann die Kennung diesen Slave angeben, um ihn von anderen Slaves zu unterscheiden.

Gemäß einer Ausführungsform der Schaltung ist das Modulatorsignal ein digitales Signal, in welchem der Ausgangswert und der Testwert einander in einer zeitlichen Abfolge abwechseln, wobei entweder der High-Zustand des digitalen Signals dann gegeben ist, wenn die Größe des Modulatorsignals gleich dem Ausgangswert ist, und der Low-Zustand des digitalen Signals dann gegeben ist, wenn die Größe des Modulatorsignals gleich dem Testwert ist, oder umgekehrt, und in die zeitliche Abfolge von Ausgangswert und Testwert ein Bitmuster und somit eine digitale Information codiert ist. In diesem Fall enthält also das Modulatorsignal eine digitale Information, z.B. ein Datenwort mit einer bestimmten Anzahl von Bits. Insbesondere kann das Modulatorsignal zu diesem Zweck frequenzmoduliert sein; die digitale Information kann durch Frequenzmodulation bzw. durch Variation der zeitlichen Abfolge von High- und Low-Zustand (oder des Tastverhältnisses zwischen Ausgangswert und Testwert) auf das Modulatorsignal aufgeprägt sein.

Gemäß einer Verfahrensvariante wird vom Modulator als Modulatorsignal ein digitales Signal erzeugt, in welchem der Ausgangswert und der Testwert einander in einer zeitlichen Abfolge abwechseln, wobei entweder der High-Zustand des digitalen Signals dann gegeben ist, wenn die Größe des Modulatorsignals gleich dem Ausgangswert ist, und der Low-Zustand des digitalen Signals dann gegeben ist, wenn die Größe des Modulatorsignals gleich dem Testwert ist, oder umgekehrt, und in die zeitliche Abfolge von Ausgangswert und Testwert ein Bitmuster und somit eine digitale Information codiert wird. Bevorzugt enthält die digitale Information eine Kennung, welche die Signalquelle identifiziert.

Gemäß einer vorteilhaften Ausführungsform weist die Schaltung ferner einen Bus, welcher insbesondere ein Feldbus oder Interface-Bus, sein kann, sowie einen daran angeschlossenen Master auf, wobei der Modulator und der Schaltgeber Bestandteile eines ebenfalls an den Bus angeschlossenen Slaves bzw. Eingangsslaves sind, welcher wenigstens zeitweise das Schaltausgangssignal, oder die Information darüber, ob dieses gleich dem ersten Wert oder gleich dem zweiten Wert ist, oder die Information darüber, ob das Schaltausgangssignal pulsiert oder nicht, in digitaler Form auf den Bus aufgibt. Bevorzugt ist hierbei der Master so eingerichtet, dass er das Schaltausgangssignal, oder die Information darüber, ob dieses gleich dem ersten Wert oder gleich dem zweiten Wert ist, oder die Information darüber, ob das Schaltausgangssignal pulsiert oder nicht, über den Bus einliest und auswertet. Falls das Schaltausgangssignal für mindestens die vorgegebene Prüfzeitspanne nicht pulsiert, gibt der Master gemäß einer Ausführungsform das Alarmsignal ab. Die Auswerteeinheit ist in diesem Fall durch den Master gebildet.

Die Schaltung weist ferner bevorzugt eine Auswerteschaltung auf, welche ebenfalls an den Bus angeschlossen ist und das Schaltausgangssignal, oder die Information darüber, ob dieses gleich dem ersten Wert oder gleich dem zweiten Wert ist, oder die Information darüber, ob das Schaltausgangssignal pulsiert oder nicht, über den Bus einliest und auswertet. Falls das Schaltausgangssignal für mindestens die vorgegebene Prüfzeitspanne nicht pulsiert, gibt die Auswerteschaltung gemäß einer Ausführungsform das Alarmsignal ab. Die Auswerteeinheit ist in diesem Fall durch die Auswerteschaltung gebildet.

Insbesondere können der Master und die Auswerteschaltung beide unabhängig voneinander das Schaltausgangssignal oder die Information darüber, ob dieses gleich dem ersten Wert oder gleich dem zweiten Wert ist, oder die Information darüber, ob das Schaltausgangssignal pulsiert oder nicht, über den Bus einlesen und auswerten.

Gemäß einer weiteren vorteilhaften Ausführungsform weist die Schaltung ferner einen Ausgangsslave auf, welcher ebenfalls an den Bus angeschlossen ist, und der Master oder die Auswerteschaltung in dem Fall, dass das Schaltausgangssignal für mindestens die vorgegebene Prüfzeitspanne nicht pulsiert, über den Bus einen Steuerbefehl an den Ausgangsslave sendet, welcher diesen veranlasst, das Alarmsignal abzugeben. Die Auswerteeinheit ist in diesem Fall durch den Ausgangsslave zusammen mit dem Master bzw. der Auswerteschaltung gebildet. Gemäß einer weiteren Ausführungsform gibt der Slave bzw. Eingangsslave eine digitale Melde-Information auf den Bus auf, wenn sich die Signalquelle im unbetätigten Zustand befindet und die Schaltschwelle kleiner ist als das Ruhesignal, wobei die Melde-Information das Alarmsignal oder das Meldesignal auslöst. Gemäß einer weiteren Ausführungsform gibt der Slave eine digitale Melde-Information auf den Bus auf, wenn sich die Signalquelle im unbetätigten Zustand befindet und die Schaltschwelle größer ist als das Ruhesignal, wobei die Melde-Information das Alarmsignal oder das Meldesignal auslöst.

Verfahrensmäßig können ein Bus, insbesondere Feldbus oder Interface-Bus, sowie ein daran angeschlossener Master verwendet werden, wobei der Modulator und der Schaltgeber Bestandteile eines ebenfalls an den Bus angeschlossenen Slaves bzw. Eingangsslaves sind, mittels welchem wenigstens zeitweise das Schaltausgangssignal oder die Information darüber, ob dieses gleich dem ersten Wert oder gleich dem zweiten Wert ist, oder die Information darüber, ob das Schaltausgangssignal pulsiert oder nicht, in digitaler Form auf den Bus aufgegeben wird. Hierbei kann z.B. mittels des Masters das Schaltausgangssignal oder die Information darüber, ob dieses gleich dem ersten Wert oder gleich dem zweiten Wert ist, oder die Information darüber, ob das Schaltausgangssignal pulsiert oder nicht, über den Bus eingelesen und ausgewertet werden.

Ferner kann eine Auswerteschaltung verwendet werden, welcher ebenfalls an den Bus angeschlossen ist und mittels welcher das Schaltausgangssignal oder die Information darüber, ob dieses gleich dem ersten Wert oder gleich dem zweiten Wert ist, oder die Information darüber, ob das Schaltausgangssignal pulsiert oder nicht, über den Bus eingelesen und auswertet wird.

Gemäß einer weiteren Variante wird ein Ausgangsslave verwendet, welcher ebenfalls an den Bus angeschlossen ist, wobei in dem Fall, dass das Schaltausgangssignal für mindestens die vorgegebene Prüfzeitspanne nicht pulsiert, mittels des Masters oder mittels der Auswerteschaltung über den Bus einen Steuerbefehl an den Ausgangsslave gesendet wird, durch welchen dieser veranlasst wird, das Alarmsignal abzugeben.

Gemäß einer Variante wird mittels des Slaves bzw. des Eingangsslaves, insbesondere im Fall (i), eine digitale Melde-Information auf den Bus aufgegeben, wenn sich die Signalquelle im unbetätigten Zustand befindet und die Schaltschwelle kleiner ist als das Ruhesignal, und durch die Melde-Information das Alarmsignal oder das Meldesignal ausgelöst.

Gemäß einer anderen Variante wird mittels des Slaves bzw. Eingangsslaves, insbesondere im Fall (ii), eine digitale Melde-Information auf den Bus aufgegeben, wenn sich die Signalquelle im unbetätigten Zustand befindet und die Schaltschwelle größer ist als das Ruhesignal, und durch die Melde-Information das Alarmsignal oder das Meldesignal ausgelöst.

Der Schaltgeber kann über eine Offset-Spannungsquelle an Masse angeschlossen sein, wobei die Offset-Spannungsquelle eine Offset-Spannung abgibt und hierdurch die Schaltschwelle des Schaltgebers um die Offset-Spannung verschiebt.

Die Schaltung kann eine weitere Schaltung enthalten oder umfassen, insbesondere zu dem Zweck, mit der weiteren Schaltung interne Signale auf Drift zu überwachen. Die Schaltung kann sich selbst überwachen. Insbesondere kann die Schaltung zusätzlich eine Schaltung umfassen, welche imstande ist, die Offset-Spannung auf Drift zu überwachen.

Verfahrensmäßig kann der Schaltgeber über eine Offset-Spannungsquelle an Masse angeschlossen sein, wobei die Offset-Spannungsquelle eine Offset-Spannung abgibt und hierdurch die Schaltschwelle des Schaltgebers um die Offset-Spannung verschoben wird. Die Offset-Spannung (oder ein anderes schaltungsinternes Signal) kann insbesondere ihrerseits nach dem erfindungsgemäßen Verfahren überwacht werden. Das elektrische Signal bzw. das Fremdsignal kann insbesondere die Offset-Spannung sein.

Die Erfindung ermöglicht die Erfüllung der Forderung von Sicherheitsnormen nach sicherheitsgerichteter Festlegung von Schaltschwellen und kann damit die Kompatibilität zwischen sicherheitsgerichteten Schaltgeräten sicherstellen.

Kurzbeschreibung der Zeichnung, in welcher schematisch anhand bevorzugter Ausführungsbeispiele der Erfindung zeigen:
- Figur 1: ein Blockschaltbild einer Ausführungsform einer nach dem erfindungsgemäßen Verfahren arbeitenden Schaltung, mit einem Sensor, einem Modulator, einem Komparator und einer Auswerteeinheit,
- Figur 2: je ein Beispiel für das zeitliche Verhalten der Modulatorspannung, welche der Modulator von Figur 1 bei betätigtem Sensor an den Komparator abgibt, sowie für das zeitliche Verhalten einer stark driftbehafteten Schwellspannung,
- Figur 3: je ein Beispiel für das zeitliche Verhalten der Schaltausgangsspannung, welche der Komparator von Figur 1 bei betätigtem Sensor an die Auswerteeinheit abgibt, sowie für das zeitliche Verhalten des von der Auswerteeinheit abgegebenen Alarmsignals, wobei die Zeitachse von Figur 3 mit derjenigen von Figur 2 übereinstimmt,
- Figur 4: je ein weiteres Beispiel für das zeitliche Verhalten der Modulatorspannung sowie für das zeitliche Verhalten einer stark driftbehafteten Schwellspannung,
- Figur 5: je ein weiteres Beispiel für das zeitliche Verhalten der Schaltaus- gangsspannung sowie für das zeitliche Verhalten des von der Auswerteeinheit abgegebenen Alarmsignals, wobei die Zeitachse von Figur 5 mit derjenigen von Figur 4 übereinstimmt,
- Figur 6: ein Blockschaltbild einer anderen Ausführungsform einer nach dem erfindungsgemäßen Verfahren arbeitenden Schaltung, mit einem Sensor, einem Modulator, einem Optokoppler und einer Auswerteeinheit,
- Figur 7: ein Beispiel für das zeitliche Verhalten des Modulatorstroms, welchen der Modulator von Figur 6 bei betätigtem Sensor an den Optokoppler abgibt, sowie für das zeitliche Verhalten eines stark driftbehafteten Schwellstroms,
- Figur 8: ein Beispiel für das zeitliche Verhalten der Schaltausgangsspannung, welche der Optokoppler von Figur 6 bei betätigtem Sensor an die Auswerteeinheit abgibt, sowie für das zeitliche Verhalten des von der Auswerteeinheit abgegebenen Alarmsignals, wobei die Zeitachse von Figur 8 mit derjenigen von Figur 7 übereinstimmt,
- Figur 9: ein weiteres Beispiel für das zeitliche Verhalten des Modulatorstroms sowie für das zeitliche Verhalten eines stark driftbehafteten Schwell- stroms,
- Figur 10: ein weiteres Beispiel für das zeitliche Verhalten der Schaltausgangs- spannung, welche der Optokoppler von Figur 6 bei betätigtem Sensor an die Auswerteeinheit abgibt, sowie für das zeitliche Verhalten des von der Auswerteeinheit abgegebenen Alarmsignals, wobei die Zeitachse von Figur 10 mit derjenigen von Figur 9 übereinstimmt,
- Figur 11: ein Blockschaltbild einer weiteren Ausführungsform einer nach dem erfindungsgemäßen Verfahren arbeitenden Schaltung, mit einem Bus, an welchen ein Master, eine Auswerteschaltung und wenigstens zwei Slaves angeschlossen sind, wovon einer den Modulator und den Komparator von Figur 1 enthält,
- Figur 12: ein Blockschaltbild einer weiteren Ausführungsform einer nach dem erfin- dungsgemäßen Verfahren arbeitenden Schaltung, mit einer Signalquelle, einem Modulator und einem Wandler,
- Figur 13: ein Beispiel für eine Signalmodulation,
- Figur 14: einen Schaltplan als Beispiel für eine Realisierung des an den Sensor und den Wandler angeschlossenen Modulators aus einzelnen Bauelementen,
- Figur 15: ein Blockschaltbild einer weiteren Ausführungsform einer nach dem er- findungsgemäßen Verfahren arbeitenden Schaltung, welche gegenüber derjenigen von Figur 12 um eine Spannungsschaltschwelle bzw. um eine Spannungsquelle und eine Spannungsüberwachung erweitert ist,
- Figur 16: eine mögliche Ausführungsform der Modulatoren der Figuren 6, 12 und 15 als Prinzipschaltbild,
- Figur 17: eine Schaltungsanordnung mit einem Zusatz-Modulator und einem Zusatz-Komparator zur Überwachung der Spannungsquelle von Figur 15 auf Drift,
- Figur 18: je ein Beispiel für das zeitliche Verhalten der Modulatorspannung, welche der Zusatz-Modulator von Figur 17 abgibt, sowie für das zeitliche Verhalten einer stark driftbehafteten Spannung,
- Figur 19: je ein Beispiel für das zeitliche Verhalten der Schaltausgangsspannung, welche der Zusatz-Komparator von Figur 17 abgibt, sowie für das zeitliche Verhalten des von der Schaltungsanordnung von Figur 17 abgegebenen Alarmsignals, wobei die Zeitachse von Figur 19 mit derjenigen von Figur 2 übereinstimmt,
- Figur 20: eine Schaltung zur Überwachung eines elektrischen Signals auf Drift, mit einem Modulator, einem Komparator und einer Auswerteeinheit,
- Figur 21: je ein Beispiel für das zeitliche Verhalten der Modulatorspannung, welche der Modulator von Figur 20 abgibt, sowie für das zeitliche Verhalten einer stark driftbehafteten Spannung unter Mitnahme bzw. Nachführung des Modulatorsignals, und
- Figur 22: je ein Beispiel für das zeitliche Verhalten der Schaltausgangsspannung, welche der Komparator von Figur 20 abgibt, sowie für das zeitliche Verhalten des von der Schaltung von Figur 20 abgegebenen Alarmsignals, wobei die Zeitachse von Figur 21 mit derjenigen von Figur 22 übereinstimmt.

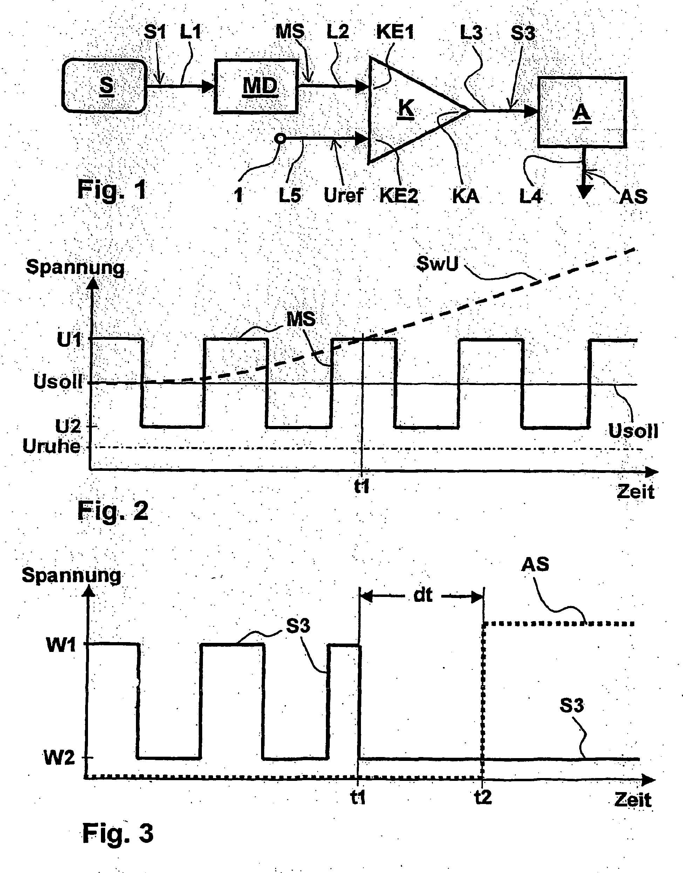

Zunächst wird auf die Figuren 1 bis 5 Bezug genommen. Figur 1 zeigt ein Blockschaltbild einer Schaltung zur Durchführung des erfindungsgemäßen Verfahrens. Die Schaltung von Figur 1 dient zur erfindungsgemäßen Überwachung der Schaltschwelle eines Komparators K auf Abweichung von einem Sollwert und weist des weiteren eine Signalquelle S, eine Auswerteeinrichtung A und einen Modulator MD auf. Der Komparator K weist einen Signaleingang KE1, einen Referenzeingang KE2 und einen Schaltausgang KA auf. Als Signalquelle S kann prinzipiell jede Gleichspannungsquelle dienen, etwa eine Batterie oder ein Längsregler Im Beispiel von Figur 1 ist die Signalquelle S ein Sensor S, welcher sich in einem betätigten und in einem unbetätigten Zustand befinden kann.

Der Sensor S kann insbesondere ein solcher mit Schaltausgang sein, insbesondere ein Näherungssensor, welcher bei Annäherung eines Gegenstandes anspricht und hierbei vom unbetätigten in den betätigten Zustand übergeht. Gemäß einem anderen Beispiel ist der Sensor S ein Temperatursensor mit Schaltausgang und geht in den betätigten Zustand über, wenn die Temperatur einen Grenzwert übersteigt, und geht zurück in den unbetätigten Zustand über, wenn die Temperatur den Grenzwert wieder unterschreitet.

Der Sensor S gibt über eine Leitung L1 an den Modulator MD als Quellensignal S1 ein Spannungssignal S1 ab, welches im betätigten Zustand des Sensors S eine vorzugsweise konstante Gleichspannung der Größe U1 und im unbetätigten Zustand ein vorzugsweise konstantes Ruhe-Spannungssignal Uruhe ist, wobei letzteres bevorzugt kein Nullsignal ist. Das Quellensignal S1 ist also entweder gleich U1 oder gleich Uruhe, je nachdem, ob der Sensor S betätigt ist oder nicht.

Der Modulator MD gibt dann, wenn der Sensor S das Ausgangs-Spannungssignal U1 abgibt und sich somit im betätigten Zustand befindet, über eine Leitung L2 ein Modulatorsignal MS an den Signaleingang KE1 des Komparators ab, welches sich fortlaufend oder zyklisch ändert zwischen dem unveränderten Ausgangswert U1 und einem Testwert U2. Das Modulatorsignal MS ist somit in diesem Beispiel ein Spannungssignal und pulsiert somit zwischen den Werten U1 und U2. Der zeitliche Verlauf des Modulatorsignals MS ist in Figur 2 als Rechteck-Kurve dargestellt.

Der Modulator MD erzeugt bei betätigtem Sensor S das Modulatorsignal MS gemäß einer bevorzugten Ausführungsform der Erfindung dadurch, dass er das Quellensignal S1 fortlaufend abwechselnd nacheinander
- unverändert an den Signaleingang KE1 des Komparators K abgibt, so dass der Ausgangswert U1 durch das unveränderte Quellensignal S1 gegeben ist,
- und, beispielsweise mittels eines Spannungsteilers, abgeschwächt an den Signaleingang KE1 des Komparators K abgibt, so dass der Testwert U2 durch das abgeschwächte Quellensignal S1 gegeben ist.

Insbesondere kann das Quellensignal S1 zugleich auch zur Stromversorgung des Modulators MD dienen, so dass dieser keinen separaten Anschluss zu einer Stromversorgung benötigt und daher mit nur geringem Aufwand installiert werden kann.

Der Komparator K gibt über seinen Schaltausgang KA und eine Leitung L3 ein Schaltausgangssignal S3 an die Auswerteeinheit A ab, welches einen ersten Wert W1 annimmt, falls die Spannung des Modulatorsignals MS größer ist als die Schaltschwelle SwU, und andernfalls einen zweiten Wert W2 annimmt.

In Figur 3 ist das Schaltausgangssignal S3 dargestellt, welches sich als Folge der zeitlichen Verläufe des Modulatorsignals MS und der Schaltschwelle SwU ergibt. Die Schaltschwelle SwU soll im vorliegenden Beispiel durch einen konstanten Sollwert Usoll gegeben sein. Zur Vorgabe dieser Schaltschwelle SwU=Usoll liegt am Referenzeingang KE2 des Komparators K über eine Klemme 1 eine Referenzspannung Uref an (Figur 1), welche gleich dem Sollwert Usoll sein soll. Es soll somit die Bedingung SwU=Uref=Usoll erfüllt sein. Solange diese Bedingung erfüllt ist, pulsiert bei betätigtem Sensor S das Schaltausgangssignal S3 im Takt des Modulatorsignals MS zwischen den Werten W1 und W2. Das Pulsieren des Schaltausgangssignals S3 zeigt an, dass der Sensor S betätigt ist und die Schaltschwelle SwU zwischen U1 und U2 liegt.

In der Praxis kann es aber auf Grund von Temperaturschwankungen, Alterung, Verschleiß, Defekt und anderen unerwünschten Einflüssen zu einer Drift der Schaltschwelle SwU kommen; ein Beispiel ist in Figur 2 als gestrichelte Kurve dargestellt, welche den zeitlichen Verlauf einer nach oben driftenden Schaltschwelle SwU zeigt. Dies kann durch ein Driften der Referenzspannung Uref bedingt sein, oder dadurch, dass aufgrund einer Drift im Inneren des Komparators K die Schaltschwelle SwU ansteigt, obwohl die Referenzspannung Uref konstant auf dem Sollwert Usoll bleibt, so dass nicht mehr SwU=Uref gilt.

Zu einem Zeitpunkt t1 überschreitet die Schaltschwelle SwU den Wert U1 (Figur 2), mit der Folge, dass das Schaltausgangssignal S3 zum Zeitpunkt t1 auf den Wert W2 abfällt und dort verbleibt, also nicht mehr pulsiert (Figur 3).

Die Auswerteeinrichtung A überwacht das Schaltausgangssignal S3 auf Pulsation und gibt über eine Leitung L4 ein Alarmsignal AS (punktierte Kurve in Figur 3) aus, wenn das Schaltausgangssignal S3 für mindestens eine vorgegebene Prüfzeitspanne dt, welche länger ist als die maximale Dauer der Pulse des Schaltausgangssignals S3, nicht pulsiert. Der Auslösezeitpunkt des Alarmsignals AS liegt daher im vorliegende Beispiel bei t2 = t1+dt. Die Drift der Schaltschwelle SwU nach oben wurde somit mit Hilfe der Erfindung festgestellt.

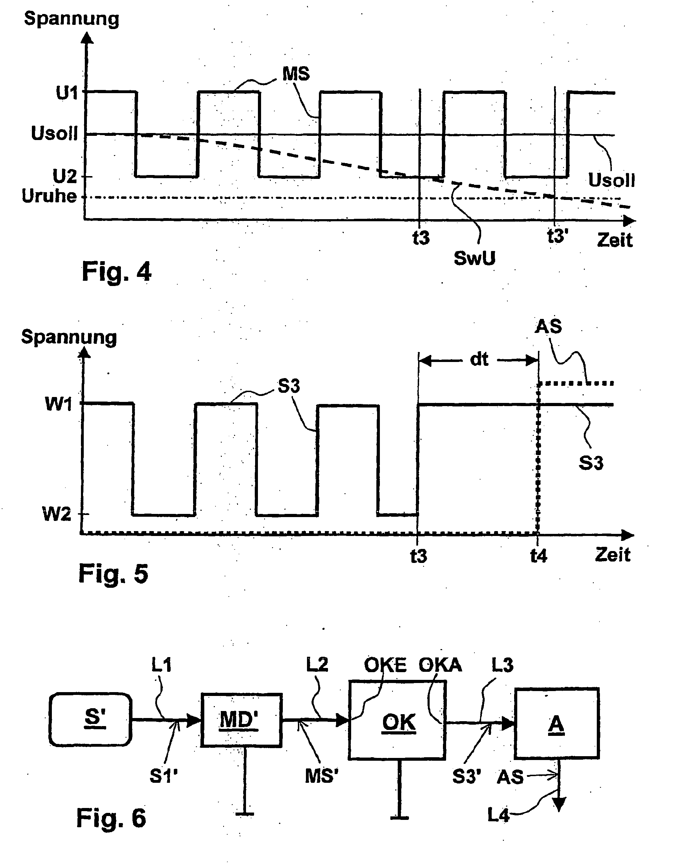

Ein Beispiel für den zeitlichen Verlauf einer nach unten driftenden Schaltschwelle SwU ist in Figur 4 gezeigt. Zu einem Zeitpunkt t3 unterschreitet die Schaltschwelle SwU den Wert U2 (Figur 4), mit der Folge, dass das Schaltausgangssignal S3 zum Zeitpunkt t3 auf den Wert W1 steigt und dort verbleibt, also nicht mehr pulsiert (Figur 5), wodurch zu einem Zeitpunkt t4=t3+dt von der Auswerteeinrichtung A das Alarmsignal AS (punktierte Kurve in Figur 5) ausgelöst wird. Auch die Drift der Schaltschwelle SwU nach unten wurde somit mit Hilfe der Erfindung festgestellt.

Der Ausgangswert U1 und der Testwert U2 bilden somit die Grenzen eines vorgegebenen Toleranzbereichs für die Schaltschwelle des Komparators K. Wenn die Schaltschwelle außerhalb des Toleranzbereichs liegt, wird das Alarmsignal AS ausgelöst. Somit zeigt das Alarmsignal AS an, dass die Schaltschwelle außerhalb des Toleranzbereichs liegt (bzw. mindestens während der Prüfzeitspanne außerhalb des Toleranzbereichs gelegen hat) und somit um mehr als einen bestimmten Betrag vom Sollwert Usoll abweicht. Das erfindungsgemäße Verfahren dient hier also dazu, die Schaltschwelle auf Abweichung von dem Sollwert Usoll zu überwachen.

In Figur 4 unterschreitet die Schaltschwelle SwU zu einem Zeitpunkt t3' auch den Ruhewert Uruhe. Gemäß einer sehr vorteilhaften Ausführungsform der Erfindung löst die Auswerteeinrichtung A das Alarmsignal AS auch dann aus, wenn sich der Sensor S im unbetätigten Zustand befindet und die Schaltschwelle SwU kleiner ist als das Ruhesignal Uruhe. Im Fall von Figur 4 wird bei dieser Ausführungsform also das Alarmsignal AS bei betätigtem Sensor S zum Zeitpunkt t4 und bei unbetätigtem Sensor S zum Zeitpunkt t3' ausgelöst. Ein wesentlicher Vorteil dieser Ausführungsform besteht somit darin, dass die Drift der Schaltschwelle SwU auch bei unbetätigtem Sensor S erkannt wird.

Der Ausgangswert U1 und der Testwert U2 weisen bevorzugt beide das gleiche Vorzeichen auf wie der Sollwert Usoll. Der Ausgangswert U1 ist betragsmäßig größer ist als der Sollwert Usoll. Der Testwert U2 ist betragsmäßig kleiner als der Sollwert Usoll, aber größer als der Ruhewert Uruhe. Bevorzugt erzeugt der Modulator MD den Testwert U2 intern durch Abschwächen des Ausgangssignals U1 z.B. mittels eines Spannungsteilers. Das Ruhesignal Uruhe weist ebenfalls das gleiche Vorzeichen auf wie der Sollwert Usoll, ist aber betragsmäßig kleiner ist als dieser.

Die Beträge der Spannungen U1 und W1 liegen bevorzugt jeweils im Bereich zwischen 3 und 10 Volt; die Beträge Spannungen U2 und W2 liegen bevorzugt jeweils im Bereich zwischen 0 und 3 Volt. Beispielsweise kann bei einem Sollwert Usoll = 4Volt U1 = 5Volt, U2 = 3Volt und Uruhe = 1 Volt oder bei einem Sollwert Usoll = -4 Volt U1 = -5Volt, U2= -3Volt und Uruhe= -1 Volt sein.

Im Beispiel der Figuren 1 bis 5 ist somit der Sollwert ein vorgegebener Soll-Spannungswert Usoll, das Modulatorsignal ein pulsierendes Spannungssignal MS, der Ausgangswert ein Ausgangs-Spannungswert U1, der Testwert ein Test-Spannungswert U2, und die Schaltschwelle des Komparators K eine Spannungsschaltschwelle SwU.

Nun wird auf die Figuren 6 bis 10 Bezug genommen. Figur 6 zeigt ein Blockschaltbild einer Ausführungsform einer Schaltung zur erfindungsgemäßen Überwachung der Schaltschwelle eines Optokopplers OK auf Abweichung von einem Sollwert, mit einer Signalquelle S', einem Modulator MD' und der Auswerteeinrichtung A.

Im Gegensatz zu dem Komparator K von Figur 1 schaltet der Optokoppler OK nicht spannungsabhängig, sondern stromabhängig, d.h. der Optokoppler OK schaltet, wenn er an seinem Signaleingang OKE ein Stromsignal erhält, welches größer ist als eine Strom-Schaltschwelle Swl. Die Signalquelle S' ist eine Gleichstromquelle, welche als Ausgangs-Stromsignal einen Gleichstrom abgibt, der das gleiche Vorzeichen aufweist wie der Sollwert, aber betragsmäßig größer ist als dieser. Im Beispiel von Figur 6 ist die Signalquelle S' ein Sensor S', welcher sich in einem betätigten und in einem unbetätigten Zustand befinden kann.

Der Sensor S' gibt über die Leitung L1 an den Modulator MD' als Quellensignal ein Stromsignal S1' ab, welches im betätigten Zustand des Sensors S' ein vorzugsweise konstanter Gleichstrom der Größe I1 und im unbetätigten Zustand ein vorzugsweise konstantes Ruhe-Stromsignal Iruhe ist, wobei letzteres bevorzugt kein Nullsignal ist. Das Quellensignal S1 ist also entweder gleich I1 oder gleich Iruhe, je nachdem, ob der Sensor S' betätigt ist oder nicht.

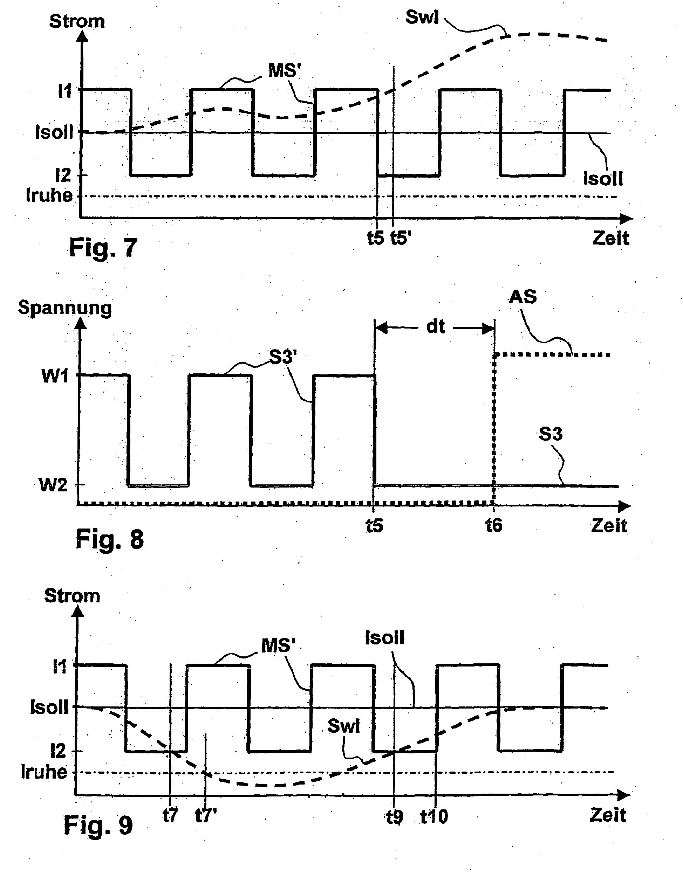

Der Modulator MD' gibt dann, wenn der Sensor S' das Ausgangs-Stromsignal I1 abgibt und sich somit im betätigten Zustand befindet, über die Leitung L2 ein Modulatorsignal MS' an den Signaleingang OKE des Optokopplers ab, welches abwechselt zwischen dem unveränderten Ausgangswert I1 und einem Testwert I2. Das Modulatorsignal MS' ist somit in diesem Beispiel ein Stromsignal und pulsiert zwischen den Werten I1 und I2. Der zeitliche Verlauf des Modulatorsignals MS' ist in Figur 7 als Rechteck-Kurve dargestellt.

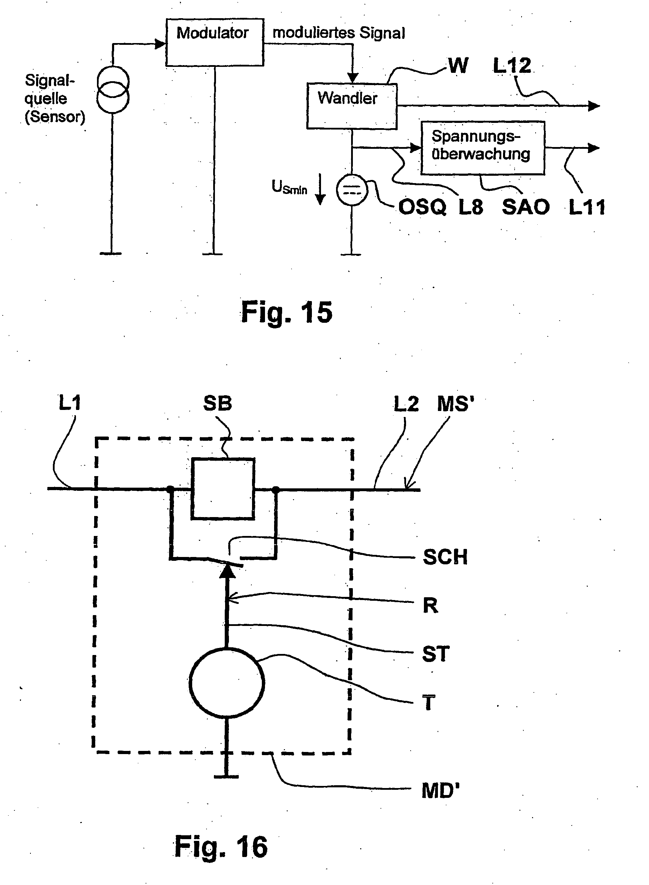

Der Modulator MD' erzeugt das Modulatorsignal MS' gemäß einer bevorzugten Ausführungsform der Erfindung (vgl. hierzu Figur 16, auf welche unten näher eingegangen wird) dadurch, dass er das Quellensignal S1' fortlaufend abwechselnd nacheinander
- unverändert an den Signaleingang OKE des Optokopplers OK abgibt, so dass der Ausgangswert I1 durch das unveränderte Stromsignal S1' gegeben ist,
- und, beispielsweise mittels eines Strombegrenzers, abgeschwächt an den Signaleingang OKE abgibt, so dass der Testwert I2 durch das strommäßig abgeschwächte Quellensignal S1' gegeben ist.

Insbesondere kann das Quellensignal S1' zugleich auch zur Stromversorgung des Modulators MD' dienen, so dass dieser keinen separaten Anschluss zu einer Stromversorgung benötigt und daher mit nur geringem Aufwand installiert werden kann.

Der Optokoppler OK gibt über seinen Schaltausgang OKA und die Leitung L3 ein Schaltausgangssignal S3' an die Auswerteeinheit A ab, welches einen ersten Wert W1 annimmt, falls der Strom des Modulatorsignals MS' größer ist als die Schaltschwelle Swl, und andernfalls einen zweiten Wert W2 annimmt.

In Figur 8 ist das Schaltausgangssignal S3' dargestellt, welches sich als Folge der zeitlichen Verläufe des Modulatorsignals MS' und der Schaltschwelle Swl von Figur 7 ergibt. Die Schaltschwelle Swl soll in dem unter Bezug auf die Figuren 6 bis 10 erläuterten Beispiel durch einen konstanten Strom-Sollwert Isoll gegeben sein. Solange diese Bedingung erfüllt ist, pulsiert das Schaltausgangssignal S3' im Takt des Modulatorsignals MS' zwischen den Werten W1 und W2. Das Pulsieren des Schaltausgangssignals S3' zeigt als an, dass die Strom-Schaltschwelle Swl zwischen I1 und I2 liegt.

In der Praxis kann es aber zu einer unerwünschten Drift der Strom-Schaltschwelle Swl kommen, so dass Swl=Isoll nicht mehr gilt; ein Beispiel ist in Figur 7 als gestrichelte Kurve dargestellt. Zu einem Zeitpunkt t5' überschreitet die Schaltschwelle Swl den Wert I1 (Figur 7), mit der Folge, dass das Schaltausgangssignal S3', welches im Rahmen seiner Pulsation zwischen den Werten W1 und W2 bereits zum Zeitpunkt t5 auf den Wert W2 abgefallen ist und sich auch zum Zeitpunkt t5' noch auf dem Wert W2 befindet, dort verbleibt, also nach dem Zeitpunkt t5 nicht mehr pulsiert.

Die Auswerteeinrichtung A überwacht das Schaltausgangssignal S3' auf Pulsation und gibt über eine Leitung L4 ein Alarmsignal AS (punktierte Kurve in Figur 8) aus, wenn das Schaltausgangssignal S3' für mindestens eine vorgegebene Prüfzeitspanne dt, welche länger ist als die maximale Pulsdauer des Schaltausgangssignals S3', nicht pulsiert. Der Auslösezeitpunkt des Alarmsignals AS liegt daher im vorliegenden Beispiel bei t6 = t5+dt. Die in Figur 7 gezeigte Drift der Schaltschwelle Swl nach oben wurde somit mit Hilfe der Erfindung festgestellt.

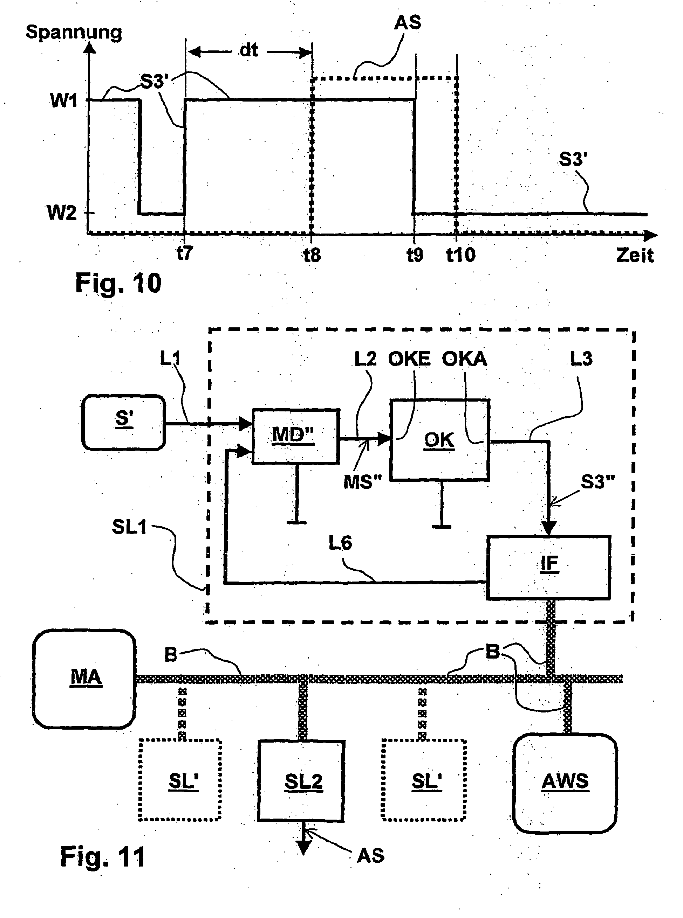

Ein weiteres Beispiel für den zeitlichen Verlauf einer driftenden Strom-Schaltschwelle Swl ist in Figur 9 gezeigt. Zu einem Zeitpunkt t7 unterschreitet die Schaltschwelle Swl den Testwert I2 (Figur 9), mit der Folge, dass das Schaltausgangssignal S3' zum Zeitpunkt t7 auf den Wert W1 steigt und dort verbleibt, also nicht mehr pulsiert (Figur 10), wodurch zu einem Zeitpunkt t8=t7+dt von der Auswerteeinrichtung A das Alarmsignal AS (punktierte Kurve in Figur 10) ausgelöst wird.

In Figur 9 unterschreitet die Schaltschwelle Swl zu einem Zeitpunkt t7' auch den Ruhewert Iruhe. Gemäß einer sehr vorteilhaften Ausführungsform der Erfindung löst die Auswerteeinrichtung A das Alarmsignal AS auch dann aus, wenn sich der Sensor S' im unbetätigten Zustand befindet und die Strom-Schaltschwelle Swl kleiner ist als das Ruhesignal Iruhe. Im Fall von Figur 9 wird bei dieser Ausführungsform also das Alarmsignal AS bei betätigtem Sensor S zum Zeitpunkt t8 und bei unbetätigtem Sensor S' zum Zeitpunkt t7' ausgelöst. Ein wesentlicher Vorteil dieser Ausführungsform besteht somit darin, dass die Drift der Schaltschwelle Swl auch bei unbetätigtem Sensor S' erkannt wird.

Zu einem Zeitpunkt t9 übersteigt im Beispiel von Figur 9 die Schaltschwelle Swl den Testwert I2 wieder, mit der Folge, dass das Schaltausgangssignal S3' beim nächsten Übergang des Modulatorsignals MS' vom Testwert I2 zum Ausgangswert I1 wieder zu pulsieren beginnt; dieser Zeitpunkt ist in den Figuren 9 und 10 mit t10 bezeichnet. Gemäß einer Variante der Erfindung wird das Alarmsignal AS daher zum Zeitpunkt t10 beendet bzw. zurückgesetzt, wie es in Figur 10 dargestellt ist.

Der Ausgangswert I1 und der Testwert I2 weisen bevorzugt beide das gleiche Vorzeichen auf wie der Sollwert Isoll. Der Ausgangswert I1 ist betragsmäßig größer ist als der Sollwert Isoll. Der Testwert I2 ist betragsmäßig kleiner als der Sollwert Isoll, aber größer als der Ruhewert Iruhe. Bevorzugt erzeugt der Modulator MD' den Testwert I2 intern durch Abschwächen des Ausgangssignals I1 z.B. mittels eines Strombegrenzers. Das Ruhesignal Iruhe weist ebenfalls das gleiche Vorzeichen auf wie der Sollwert Isoll, ist aber betragsmäßig kleiner ist als dieser.

Beispielsweise kann bei einem Sollwert Isoll = 12mA der Wert I1 = 20mA, der Wert I2 = 4mA und der Wert Iruhe = 2mA oder bei einem Sollwert Isoll = -12mA der Wert I1 = -20mA, der Wert I2= -4mA und der Wert Iruhe= -2mA sein.

Im Beispiel der Figuren 6 bis 10 ist somit der Sollwert ein vorgegebener Soll-Stromwert Isoll, das Modulatorsignal ein zwischen I1 und I2 pulsierendes Stromsignal MS', der Ausgangswert ein Ausgangs-Stromwert I1, der Testwert ein Test-Stromwert 12, und die Schaltschwelle des Optokopplers OK eine Strom-Schaltschwelle Swl.

In den unter Bezug auf die Figuren 1 bis 10 erläuterten Beispielen sind die Schaltausgangssignale S3,S3' Spannungssignale, welche jeweils die Spannungswerte W1 oder W2 annehmen können. Gemäß alternativer Varianten können die Schaltausgangssignale S3,S3' Stromsignale sein, welche jeweils zwei verschiedene Stromwerte annehmen können, wobei insbesondere einer dieser Stromwerte gleich Null sein kann.

Nun wird auf Figur 11 Bezug genommen, welche schematisch als ein Beispiel für eine weitere Ausführungsform einer Schaltung zur Durchführung des erfindungsgemäßen Verfahrens in Form eines Blockschaltbildes ein Feldbus- oder Interface-Bussystem zeigt, mit einem Bus B, an welchen ein Master MA, Eingangsslave SL1, ein Ausgangsslave SL2 und eine Auswerteschaltung AWS angeschlossen sind. Der Sensor S' ist an den Eingangsslave SL1 angeschlossen.

Der Slave SL umfasst einen Modulator MD", den Optokoppler von Figur 6 sowie ein Interface IF. An den Bus B können für weitere Funktionen weitere Slaves SL' angeschlossen sein; diese sind für das vorliegende Ausführungsbeispiel ohne Belang und daher gestrichelt dargestellt. Der Sensor S' gibt über die Leitung L1 an den Modulator MD" das Stromsignal S1' ab, welches bereits unter Bezug auf die Figuren 6 bis 10 erläutert wurde und welches entweder gleich I1 oder gleich Iruhe ist, je nachdem, ob der Sensor S' betätigt ist oder nicht.

Der Modulator MD" von Figur 11 unterscheidet sich vom Modulator MD' von Figur 6 dadurch, dass der Modulator MD" einen zusätzlichen Eingang aufweist, an welchen eine Leitung L6 angeschlossen ist, und dadurch, dass der Modulator MD" bei betätigtem Sensor S' ein digitales Modulatorsignal MS" mit darin enthaltener digitaler Information an den Signaleingang OKE Optokopplers OK abgibt. Das digitale Modulatorsignal kann ein Spannungssignal sein, ist jedoch bevorzugt ein Stromsignal.

Der Modulator MD" gibt dann, wenn der Sensor S' das Ausgangs-Stromsignal I1 abgibt und sich somit im betätigten Zustand befindet, über die Leitung L2 das Modulatorsignal MS" an den Signaleingang OKE des Optokopplers OK ab, welches abwechselt zwischen dem unveränderten Ausgangswert I1 und dem Testwert I2. Das vom Modulator MD" abgegebene Stromsignal MS" pulsiert somit zwischen den Werten I1 und I2. Die Leitung 6 verbindet das Interface IF mit dem Modulator MD".

Der Optokoppler OK gibt über seinen Schaltausgang OKA und die Leitung L3 ein Schaltausgangssignal S3" an das Interface IF ab. Das Schaltausgangssignal S3" nimmt den ersten Wert W1 an, falls das vom Modulator MD" abgegebene Stromsignal MS" größer ist als die Schaltschwelle Swl, und nimmt andernfalls den zweiten Wert W2 an.

Das vom Modulator MD" bei betätigtem Sensor S' abgegebene Stromsignal MS" ist, wie bereits erwähnt, ein digitales Signal, in welchem der Ausgangswert I1 und der Testwert I2 einander in einer zeitlichen Abfolge abwechseln, wobei in die zeitliche Abfolge von Ausgangswert I1 und Testwert 12 ein Bitmuster und somit eine digitale Information (z.B. ein Datenwort oder eine bestimmte Bitfolge) codiert ist, welche z.B. den Sensor S' identifiziert oder eine sonstige Kennung und/oder z.B. Messdaten enthält; d.h. die Pulse des Signals MS" sind unterschiedlich lang.

Solange die Schaltschwelle Swl des Optokopplers OK zwischen I1 und I2 liegt, pulsiert das Schaltausgangssignal S3" im Takt des vom Modulator MD" abgegebene Signals MS", d.h. auch das Schaltausgangssignal S3" enthält im Fall der Schaltungsanordnung von Figur 11 die digitale Information. Diese wird somit mit dem Schaltausgangssignal S3" über die Leitung L3 an das Interface IF übertragen.

Der Master MA kommuniziert zyklisch nacheinander zumindest unidirektional mit allen an den Bus B angeschlossenen Slaves und somit einmal je Zyklus auch mit dem Interface IF. Das Interface IF überträgt die genannte digitale Information, welche es über die Leitung L3 erhalten hat, einmal je Zyklus auf den Bus B. Der Inhalt der so vom Interface IF auf den Bus B übertragenen digitalen Information kann von Zyklus zu Zyklus verschieden sein. Die digitale Information kann insbesondere die Information darüber enthalten, ob das Schaltausgangssignal S3" pulsiert oder nicht. Vorzugsweise enthält die digitale Information zusätzlich zu der Information darüber, ob das Schaltausgangssignal S3' pulsiert oder nicht, auch eine digitale Kennung des Sensors S' oder des Slaves SL1, welche den Sensor S' bzw. den Slave SL1 identifiziert. Über die Leitung L6 synchronisiert das Interface IF den Betrieb des Modulators MD" mit den Buszyklen. Das Interface IF kann z.B. ein Mikroprozessor sein.

Gemäß einer Variante liest der Master MA die Information darüber, ob das Schaltausgangssignal S3" pulsiert oder nicht, über den Bus B ein (vorzugsweise einmal in jedem Zyklus), wertet diese aus und veranlasst die Ausgabe des Alarmsignals AS, falls das Schaltausgangssignal S3" für mindestens die Prüfzeitspanne dt nicht pulsiert. Bei dieser Variante wird die Auswerteschaltung AWS von Figur 11 nicht benötigt und kann weggelassen werden; ihre Funktion wird bei dieser Variante vom Master MA übernommen.

Gemäß einer anderen Variante liest die Auswerteschaltung AWS die Information darüber, ob das Schaltausgangssignal S3" pulsiert oder nicht, über den Bus B ein (vorzugsweise einmal in jedem Zyklus), wertet diese aus und veranlasst die Ausgabe des Alarmsignals AS, falls das Schaltausgangssignal S3" für mindestens die Prüfzeitspanne dt (welche bei dieser Variante des Verfahrens länger ist als die maximale Pulsdauer des Modulatorsignals MS") nicht pulsiert. Der Master MA bzw. die Auswerteschaltung AWS lesen also vorzugsweise in jedem Zyklus die vom Slave SL1 stammende digitale Information über den Bus B ein und informieren sich somit darüber, ob die Schaltschelle Swl zwischen den Werten I1 und I2 liegt oder nicht.

Die Schaltung von Figur 11 weist ferner einen Ausgangsslave SL2 auf, welcher ebenfalls an den Bus B angeschlossen ist, wobei der Master MA bzw. die Auswerteschaltung AWS in dem Fall, dass das Schaltausgangssignal S3' für mindestens die vorgegebene Prüfzeitspanne dt nicht pulsiert, über den Bus B einen Steuerbefehl an den Ausgangsslave SL2 senden, welcher diesen veranlasst, das Alarmsignal AS abzugeben, d.h. der Master MA oder die Auswerteschaltung AWS veranlassen die Ausgabe des Alarmsignals AS, falls das Schaltausgangssignal S3" für mindestens die Prüfzeitspanne dt nicht pulsiert, vorzugsweise durch Senden eines entsprechenden Steuerbefehls über den Bus B an den Ausgangsslave SL2.

Selbstverständlich ist die unter Bezug auf Figur 11 erläuterte Vorgehensweise völlig entsprechend unter Verwendung von Spannungssignalen anstelle der erwähnten Stromsignale möglich.

Figur 16 zeigt eine von vielen möglichen Ausführungsformen des Modulators MD' von Figur 6 als Prinzipschaltbild, welcher über die Leitung L1 mit der Signalquelle bzw. dem Sensor S1' und über die Leitung L2 mit dem Optokoppler OK verbunden ist, wie in Figur 6 dargestellt.

Gemäß dem Ausführungsbeispiel von Figur 16 sind die Leitungen L1 und L2 über einen Strombegrenzer SB miteinander verbunden. Zum Strombegrenzer SB ist ein steuerbarer Schalter SCH parallel geschaltet, so dass dieser im geschlossenen Zustand den Strombegrenzer SB überbrückt.

Der steuerbare Schalter SCH wird von einem Taktgeber T über eine Steuerleitung ST mit einem Rechtecksignal R so gesteuert, dass der Schalter fortlaufend abwechselnd öffnet und schließt. Bei geschlossenem Schalter SCH gelangt das Quellensignal S1', welches bevorzugt ein Stromsignal ist, unverändert auf die Leitung L2. Bei betätigtem Sensor S' und geschlossenem Schalter SCH gelangt daher das Stromsignal I1 an den Signaleingang OKE des Optokopplers OK (vgl. Figuren 6 und 7). Bei betätigtem Sensor S' und geöffnetem Schalter SCH hingegen wird das Stromsignal S1' durch den Strombegrenzer SB abgeschwächt auf den Wert I2 (vgl. Figur 7). Der Wert I2 wird somit durch Abschwächen des Quellensignals S1' erzeugt. Das über die Leitung L2 zum Optokoppler OK gelangende Stromsignal MS' (Figur 7) pulsiert somit zwischen den Werten I1 und I2, sofern der Sensor S' betätigt ist.

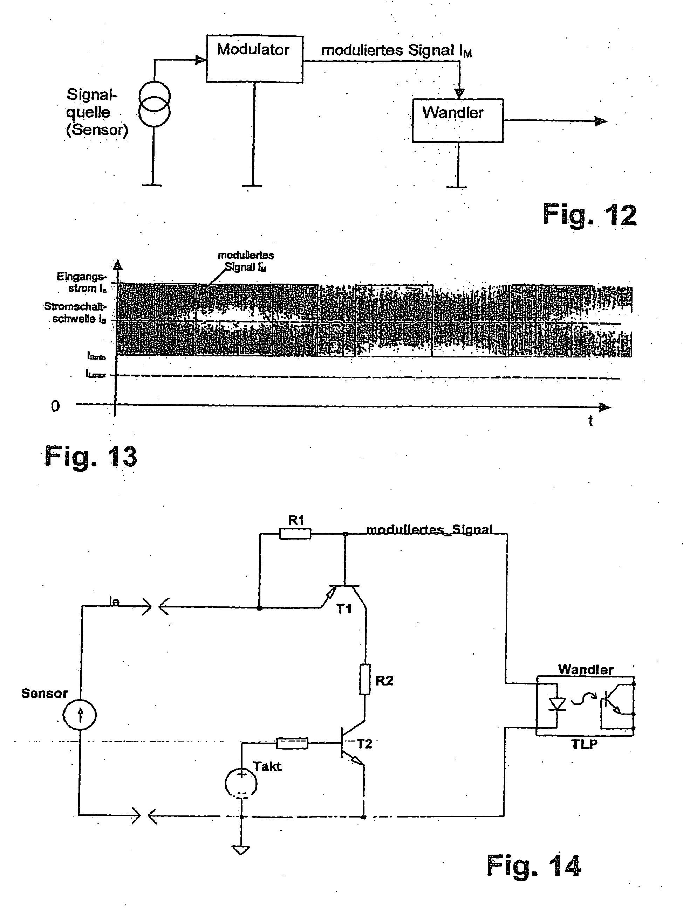

Der Modulator MD' von Figur 16 kann z.B. aus einzelnen Bauelementen aufgebaut sein wie in Figur 14 dargestellt. Auch die Modulatoren der Schaltungen der Figuren 12 und 15 können jeweils durch den Modulator MD' von Figur 16 gebildet sein. Im folgenden wird der Schaltgeber auch als Wandler bezeichnet.

Die Erfindung betrifft die sichere Überwachung der Strom- und Spannungsschaltschwelle driftbehafteter Bauteile

### 1. Umfeld:

Die hier beschriebenen Schaltungstechniken finden Anwendung im Bereich der Funktionalen Sicherheit zum Zwecke des Personen- oder Maschinenschutzes.

Geräte, die sicherheitsgerichtete Funktionen ausführen, können sowohl aus elektromechanischen Komponenten (Schalter, Relais), als auch aus elektronischen Bauteilen bestehen.

Sicherheitsgeräte aus diesem Bereich zeichnen sich dadurch aus, dass sie Sicherheitsfunktionen mit sehr hoher Zuverlässigkeit ausführen. Es wird von den Sicherheitsgeräten gefordert, dass die Ausführung der Sicherheitsfunktion auch durch den Defekt von Teilkomponenten nicht beeinträchtigt wird. Beispiele für Defekte von Komponenten sind Kurzschlüsse, Unterbrüche und Drift elektrischer Parameter.

Übliche Verfahren, die dazu dienen, Sicherheitsfunktion bei Auftreten von Komponentenfehlern aufrecht zu erhalten, sind:
- Redundanz von Komponenten:
   Mehrere Komponenten erfüllen die gleiche Sicherheitsfunktion. Dabei muss jede Komponente für sich alleine die Sicherheitsfunktion ausführen können, auch wenn die anderen redundanten Komponenten defekt sind. Schaltungen mit Redundanz versagen leichter bei Drift durch Einflüsse gemeinsamer Ursache (z.B. Temperatur). Redundante Kanäle, die gemeinsam ein Schaltsignal überwachen, sind schwer elektrisch zu entkoppeln. Damit sind die redundanten Kanäle nicht mehr völlig unabhängig; der Anteil der Fehler gemeinsamer Ursache im Gesamtsystem steigt und erhöht das gefährliche Ausfallrisiko.
- Fehlererkennung durch Diagnose: Die korrekte Funktion einer Komponente wird durch eine hinzugefügte Diagnosekomponente überwacht. Erkennt die Diagnose einen sicherheitsrelevanten Komponentenfehler, meldet sie den Fehler weiter oder führt über einen unabhängigen Wirkmechanismus die Sicherheitsfunktion präventiv aus.

### 2. Besondere Probleme bei elektronischen Komponenten:

Kurzschlüsse und Unterbrüche sind Fehler, die eher allgemeingültig alle elektrische Komponenten betreffen. Bei elektronischen Komponenten tritt je nach Anwendung die Drift elektrischer Parameter in den Vordergrund. Sie sind schwerer zu erkennen und zu beherrschen, als Kurzschlüsse oder Unterbrüche. Die Beherrschung oder Erkennung der Drift elektrischer Parameter bei Komponenten ist von Bedeutung bei:
- der Übermittlung sicherheitsgerichteter analoger Signale mit kontinuierlichem Wertebereich, oder
- bei der Auswertung digitaler Signale mit sicherheitsgerichteten Schaltschwellen.

### 3. Anwendungsbereich der Erfindung:

Die Erfindung löst das Problem der Erkennung der Drift von Schaltschwellen bei Komponenten, die der Auswertung sicherheitsgerichteter digitaler Signale dienen. Anwendbar sind die Erfindungen auf digitale Signale, deren Zustände über Spannungs- und/oder Strombereiche definiert sind. Beispiele hierfür, sind Schaltsignale nach IEC 61131-2 Typ 2, einer üblichen Definition für Sensor-Schaltsignale, digitale IO-Baugruppen und Steuerungen, welche die Kompatibilität der Baugruppen über Herstellergrenzen hinweg gewährleisten soll.

In zunehmendem Maße werden auch in der Sicherheitstechnik elektrische Signale nicht nur rein digital betrachtet, sondern es werden auch die Grenzwerte der Schaltschwellen nach Vorbild des Standards IEC 61131-2 Typ 2 sicherheitsgerichtet festgelegt. Beispiel für diesen Trend ist die Festlegung der Schaltschwellen in der Sicherheitsnorm für berührungslos wirkende Schutzeinrichtungen IEC 61496-1:2004.

### 4. Sichere Drifterkennung der Stromschaltschwelle:

Die nachfolgend beschriebene Anordnung zeichnet sich durch folgende Fähigkeiten aus:
- Sicherheitsgerichtete Auswertung eines Stromschaltsignals mit sicherer Erkennung der Drift der Stromschaltschwelle unter einen definierten Toleranzbereich.
- Wandlung eines statischen sicheren Eingangsstromsignals in ein driftunempfindliches dynamisches Ausgangssignal.
- Die Drifterkennung ist bei aktivem (stromführenden) Eingangssignal ohne Zustandswechsel des Eingangssignals möglich.
- Die sicherheitsgerichteten Signalpfade können vollständig aus dem Signalstrom gespeist werden. Dies verhindert gefährliche Leckströme aus externen Stromversorgungen, die zur Verfälschung des Sicherheitssignals führen können.
- Die Anordnung kann mit der unten beschriebenen Anordnung zur sicheren Drifterkennung einer Spannungsschaltschwelle kombiniert werden.

### 4.1. Prinzip der Signalauswertung:

Die Anordnung ist als stromziehender digitaler Eingang konzipiert.

Aufgabe der Anordnung ist es, ein statisches sicheres Eingangsstromsignal in ein driftunempfindliches dynamisches Ausgangssignal zu wandeln. Der Schaltzustand des Ausgangssignals ist dabei nicht über Spannungs- oder Strompegel definiert, sondern über eine Frequenzmodulation, um eine Fehlererkennung (Diagnose) zu realisieren. Es gilt nachfolgende Signalzuordnung:

**Tabelle 1: Signalzuordnung**

| Eingang | Ausgang |
|---|---|
| statischer Low-Pegel | statisches Ausgangssignal |
| statischer High-Pegel | dynamisches Ausgangssignal |

Zum Zwecke der Signalwandlung wird auf den statischen Eingangsstrom ein dynamisches Taktsignal aufmoduliert.

Figur 12 zeigt ein Blockschaltbild einer Ausführungsform einer Schaltung zur Durchführung des erfindungsgemäßen Verfahrens. Figur 13 zeigt ein Beispiel für eine Signalmodulation.

Die obere Grenze des modulierten Stromsignals I_{M} resultiert aus dem statischen Eingangsstrom Iₑ. Die untere Grenze bzw. der Gleichstrom-Offset I_{Smin} des modulierten Stromsignals I_{M} markiert die untere Grenze des Toleranzbandes, in dem sich die Stromschaltschwelle des Wandlers bewegen darf. Somit wird der Gleichstrom-Offset I_{Smin} so dimensioniert, dass er mit dem sicherheitsgerichteten geforderten maximalen Strom für den Ausschaltzustand I_{Lmax} zusammenfällt oder ihn übersteigt. Der Gleichstrom-Offset I_{Smin} hat das Verhalten eines Konstantstroms. Solange der Eingangsstrom diese untere Grenze nicht überschreitet besteht das Signal aus einem reinen Gleichanteil. Die Schaltschwelle I_{S} des Wandlers liegt oberhalb des Gleichstrom-Offset I_{Smin}.

Bei aktivem Eingangssignal Iₑ > I_{S} wechselt das modulierte Signal I_{M} im Takt des Wechselsignals über bzw. unter die Stromschaltschwelle I_{S} des Wandlers. Der Wandler überträgt das Wechselsignal in digitalisierter Form.

Bei inaktivem Eingangssignal lₑ < I_{S} liegt der Eingangsstrom Iₑ statisch unterhalb der Schaltschwelle I_{S}. Der Wandler überträgt ein statisches Signal, das dem sicheren Zustand entspricht.

### 4.2. Drifterkennung:

Eine gefährliche Situation tritt ein, wenn die Schaltschwelle I_{S} des Modulators durch Drift (Komponentenfehler) unter den sicherheitsgerichteten maximalen Ausschaltpegel I_{Lmax} fällt. Dadurch könnte ein inaktives Eingangssignal Iₑ < I_{Lmax} wegen zu hoher Empfindlichkeit des Wandlers als aktives Signal missinterpretiert werden und zu einem gefährlichen Zustand führen.

In der oben beschriebenen Anordnung läge in diesem Fehlerfall die Schaltschwelle I_{S} unterhalb des Gleichstrom-Offsets I_{Smin}. Der Wandler überträgt dadurch ein statisches Signal, das zur Erkennung des Komponentenfehlers herangezogen werden kann.

### 4.3. Beispiele für die Realisierung des Wandlers:

Als Wandler sind elektronische Anordnungen geeignet, die eine Schaltschwelle realisieren, wie Optokoppler, Transistoren, Differenzverstärker

### 4.4. Beispiel einer Realisierung des Modulators:

Figur 14 zeigt ein Beispiel einer Realisierung des Modulators. Der Eingangsstrom Iₑ fließt bei kleinen Strömen (Iₑ < I_{Smin}) zunächst vollständig als Gleichstrom über den Widerstand R1. Der Transistor T1 ist vollständig gesperrt. Steigt der Eingangsstrom Iₑ über die untere Begrenzung des Toleranzbands der Schaltschwelle Iₑ > I_{Smin}, beginnt der Transistor T1 zu leiten und ermöglicht T2 einen Teil des Eingangsstroms gegen Masse abzuleiten. Der Transistor T2 wird von einem Taktgenerator angesteuert. Ist T2 gesperrt, wird der Strom Iₑ vollständig an den Wandler weitergeleitet. Ist T2 leitend, begrenzt T1 das modulierte Signal I_{M} durch die Stromableitung zum Wandler auf I_{Smin}. Dadurch entsteht ein Strom mit einem Gleichstrom-Offset I_{Smin} und einem Wechselanteil Iₑ -I_{Smin}.

### 4.5. Beispiele für das Modulationsverfahren:

Für die Modulation sind alle Wechselsignale geeignet, wie sinusförmige Wechselspannungen, digitale Takte oder codierte Signale.

### 5. Sicherung der Spannungsschaltschwelle:

Übliche Schnittstellen definieren die Signalzustände meist nicht nur über den Strom, sondern auch über die Spannung des Signals.

Die obige Anordnung kann so erweitert werden, dass neben einer minimalen Stromschaltschwelle auch eine minimale Spannungsschaltschwelle U_{Tmax} sicherheitsgerichtet überwacht werden kann.

Figur 15 zeigt ein Blockschaltbild mit Erweiterung um eine Spannungsschaltschwelle. Um eine minimale Spannungsschaltschwelle zu gewährleisten, wird der Wandler, anstatt auf Masse, auf ein höheres Bezugspotential gelegt. Dieses Bezugspotential U_{Smin} entspricht oder liegt über der geforderten minimalen Spannungsschaltschwelle U_{Tmax}. Da sich das Eingangssignal weiterhin auf Masse bezieht, kann der Wandler erst von einem Strom durchflossen werden, wenn die Eingangsspannung U_{Smin} übersteigt. Je nach Sicherheitsanforderung kann die Spannung U_{Smin} zusätzlich sicher überwacht werden.

Das modulierte Stromsignal I_{M} kann dem Modulatorsignal S3' entsprechen bzw. äquivalent sein. Ebenso kann der statische Eingangsstrom Iₑ dem Strom-Ausgangswert I1 entsprechen bzw. äquivalent sein. Ebenso kann der Gleichstrom-Offset I_{Smin} dem Strom-Testwert I2 entsprechen bzw. äquivalent sein. Ebenso kann die Stromschaltschwelle Iₛ der Schaltschwelle Swl entsprechen bzw. äquivalent sein. Ebenso kann der maximale Ausschaltpegel I_{Lmax} dem Strom-Ruhesignal Iruhe entsprechen bzw. äquivalent sein. Bevorzugt ist Iₑ = I1, I_{Smin}=I2, I_{S}=Swl und I_{Lmax}=Iruhe. Das Bauelement bzw. die Schaltung "Takt" von Figur 14 kann mit dem Taktgeber T von Figur 16 identisch oder äquivalent sein.

Der Schaltgeber bzw. Wandler W von Figur 15 kann z.B. ein Optokoppler sein, welcher über eine Leitung L12 entsprechend der oben erläuterten Weise ein Schaltausgangssignal an eine in Figur 15 nicht gezeigte Auswerteeinrichtung abgibt, und dessen Schaltschwelle in der oben bereits erläuterten erfindungsgemäßen Weise auf Drift überwacht wird, nämlich durch Überwachung des Schaltausgangssignals auf Pulsation. Der Modulator von Figur 15 kann z.B. durch den Modulator MD' von Figur 6 gebildet sein; ebenso kann die Signalquelle von Figur 15 durch den Sensor S' von Figur 6 gebildet sein. Der Wandler W von Figur 15 kann durch den Optokoppler OK von Figur 6 gebildet sein. Die an Leitung L12 angeschlossene, in Figur 15 nicht dargestellte Auswerteeinrichtung kann durch die Auswerteeinrichtung A von Figur 6 gebildet sein.

Die Schaltung von Figur 15 ist gegenüber derjenigen von Figur 12 um eine Offset-Spannungsquelle OSQ und eine Spannungsüberwachung erweitert, welche dazu dient, die von der Offset-Spannungsquelle OSQ abgegebene Offset-Spannung Usmin auf Drift zu überwachen, d.h. mit Hilfe der Schaltung von Figur 15 wird nicht nur die Schaltschwelle des Wandlers W erfindungsgemäß auf Drift überwacht, sondern es wird zusätzlich auch die Offset-Spannung Usmin erfindungsgemäß auf Drift überwacht. Die Offset-Spannungsquelle OSQ ist zwischen den Wandler W und Masse zwischengeschaltet, d.h. der Wandler W ist über die Offset-Spannungsquelle OSQ an Masse gelegt, wodurch sich die Schaltschwelle des Wandlers W um die Offset-Spannung Usmin verschiebt (aber dennoch in erfindungsgemäßer Weise überwacht wird wie oben erläutert). Die Größe der Offset-Spannung Usmin kann z.B. durch eine Schnittstellen-Definition, eine Norm oder einen Industrie-Standard vorgegeben sein.

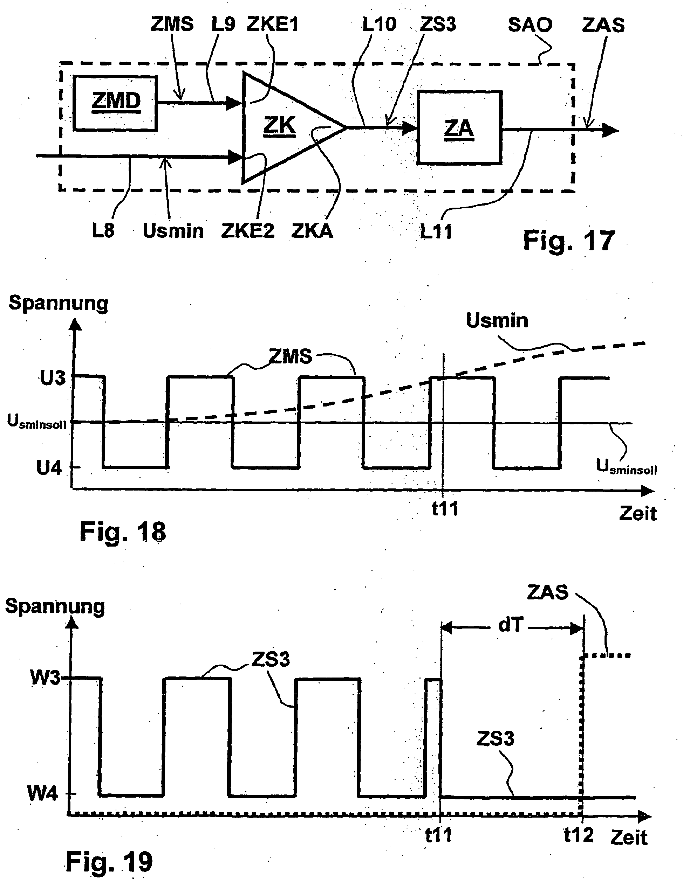

Von der Verbindung zwischen Wandler W und Offset-Spannungsquelle OSQ zweigt eine Leitung L8 ab, über welche die Offset-Spannung Usmin an eine Schaltungsanordnung SAO angelegt ist. Diese dient zur Überwachung der Offset-Spannung Usmin auf Drift in erfindungsgemäßer Weise. Ein Ausführungsbeispiel für eine derartige Schaltungsanordnung SAO ist in Figur 17 dargestellt; andere Ausführungen sind selbstverständlich möglich. Die Schaltungsanordnung SAO von Figur 17 umfasst einen Zusatzmodulator ZMD, einen Zusatz-Schaltgeber ZK, welche im vorliegenden Beispiel als Komparator ZK ausgebildet ist, sowie eine Zusatz-Auswerteeinheit ZA.

Die Offset-Spannung Usmin ist über die Leitung L8 an den Referenzeingang ZKE2 des Komparators ZK angelegt und bildet bzw. liefert somit die Schaltschwelle des Komparators ZK. Der gewünschte Wert für die Offset-Spannung Usmin (d.h. deren Sollwert) sei durch einen Wert Usminsoll gegeben (Figur 18).

An den Signaleingang ZKE1 des Komparators ZK ist über eine Leitung L9 ein Zusatz-Modulatorsignal ZMS angelegt, welches von dem Zusatz-Modulator ZMD erzeugt wird und welches sich fortlaufend oder zyklisch ändert zwischen einem Ausgangswert U3, welcher größer ist als der Sollwert Usminsoll, und einem Testwert U4, welcher kleiner ist als der Sollwert Usminsoll (Figur 18).

Der Komparator ZK gibt über seinen Schaltausgang ZKA und eine Leitung L10 ein Zusatz-Schaltausgangssignal ZS3 ab, welches einen Wert W3 annimmt, falls das Zusatz-Modulatorsignal ZMS größer ist als die Schaltschwelle des Zusatz-Schaltgebers ZK, und andernfalls einen Wert W4 annimmt.

Daher pulsiert das Zusatz-Schaltausgangssignal ZS3 dann im Takt des Zusatz-Modulatorsignals ZMS zwischen den Werten W3 und W4, wenn die Schaltschwelle Usmin des Komparators ZK zwischen den Werten U3 und U4, also in einem von den Werten U3 und U4 begrenzten Toleranzbereich liegt, und somit um höchstens eine vorgegebene Differenz von dem Sollwert Usminsoll abweicht; andernfalls, nämlich wenn die Schaltschwelle Usmin außerhalb dieses Toleranzbereichs liegt, pulsiert das Zusatz-Schaltausgangssignal ZS3 nicht (Figur 19).

Zu einem Zeitpunkt t11 übersteigt die Spannung Usmin auf Grund einer Drift den Wert U3 (Figur 18) und verlässt somit den von den Werten U3 und U4 begrenzten Toleranzbereich, so dass das Zusatz-Schaltausgangssignal ZS3 bei t11 aufhört zu pulsieren (Figur 19).

Die Leitung L10 (Figur 17) führt das Zusatz-Schaltausgangssignal ZS3 der Zusatz-Auswerteeinrichtung ZA zu, welche das Zusatz-Schaltausgangssignal ZS3 auf Pulsation überwacht und ein Zusatz-Alarmsignal ZAS (Figur 19) auslöst und über die Leitung L11 abgibt, wenn das Zusatz-Schaltausgangssignal ZS3 für mindestens eine vorgegebene Wartezeitspanne bzw. Prüfzeitspanne dT nicht pulsiert. Diese Zeitspanne ist länger als die maximale Pulsdauer des Signals ZS3 und läuft zum Zeitpunkt t12 = t11+dT ab, weshalb zu diesem Zeitpunkt das Zusatz-Alarmsignal ZAS ausgelöst wird (Figur 19).

Die Schaltungsanordnung SAO überwacht auf erfindungsgemäße Weise die Schaltschwelle des Komparators ZK auf Abweichung von dem Sollwert Usminsoll. Da diese Schaltschwelle durch die Offset-Spannung Umin gegeben ist, wird auf diese Weise mit der Schaltschwelle auch die Offset-Spannung Usmin erfindungsgemäß überwacht. Die Schaltungsanordnung SAO ist somit zugleich auch eine Schaltungsanordnung zur Überwachung einer Spannung, hier der Spannung Usmin, auf Drift. Da Stromsignale in Spannungssignale umsetzbar sind, kann die Schaltungsanordnung SAO auch zur Überwachung eines Stromsignals auf Drift herangezogen werden. Diese Aussagen sind ebenso für die Schaltung gemäß Figur 1 zutreffend.

Die Schaltungsanordnung SAO von Figur 17 kann innerhalb der Schaltungsanordnung von Figur 15 zum Einsatz kommen. Allgemein können alle Spannungs- und Stromsignale innerhalb einer Schaltung zur Durchführung des erfindungsgemäßen Verfahrens mit einer weiteren derartigen Schaltung auf Drift überwacht werden. Eine Schaltung zur Durchführung des erfindungsgemäßen Verfahrens kann allgemein zur Überwachung beliebiger elektrischer Signale auf Drift dienen.

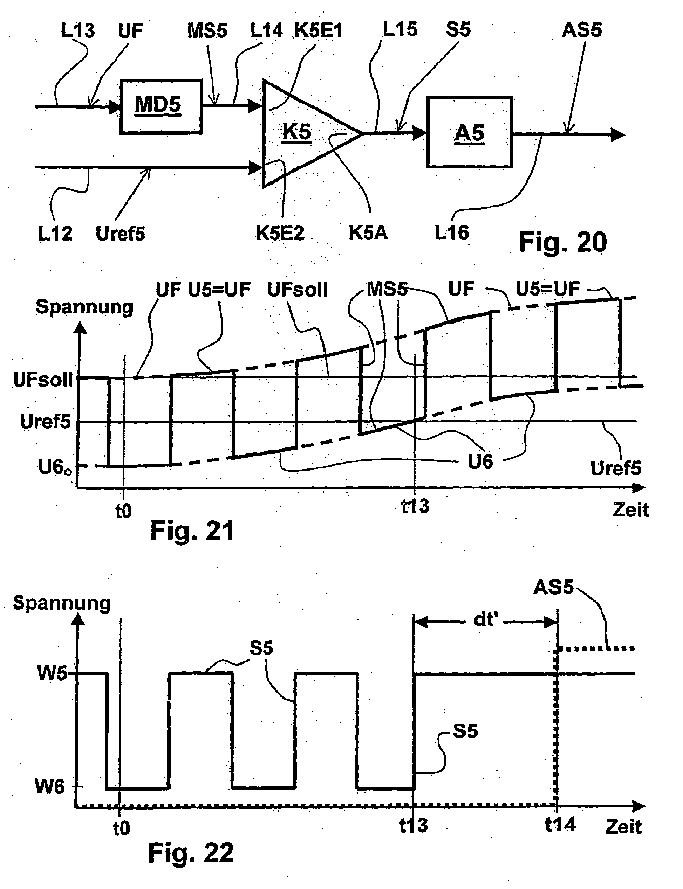

Nun wird auf die Figuren 20 bis 22 Bezug genommen. Die Schaltung von Figur 20 dient zur Überwachung eines elektrischen Signals UF, welches im vorliegenden Beispiel ein im folgenden als Fremdsignal bezeichnetes Spannungssignal UF ist, auf Abweichung von einer Sollspannung UFsoll, und weist eine Auswerteeinrichtung A5, einen Modulator MD5 und einen Schaltgeber K5 auf.

Der Schaltgeber K5 ist ein Komparator, an dessen Referenzeingang K5E2 über eine Leitung L12 eine Referenzspannung Uref5 angelegt ist, welche die Schaltschwelle des Komparators K5 vorgibt (d.h. die Schaltschwelle ist durch die Referenzspannung eindeutig festgelegt; im vorliegenden Beispiel ist die Schaltschwelle mit der Referenzspannung identisch). Die Spannung Uref5 ist im vorliegenden Beispiel kleiner als der Sollwert UFsoll und wird von einer nicht gezeigten Spannungsquelle bereitgestellt. Dem Modulator MD5 ist eine nicht dargestellte Signalquelle vorgeschaltet, welche über eine Leitung L13 das auf Abweichung von der Sollspannung UFsoll zu überwachendes Quellensignal, nämlich ein Fremdsignal UF an den Modulator MD5 abgibt.

Der Modulator MD5 gibt über eine Leitung L14 ein Modulatorsignal MS5 an den Signaleingang K5E1 des Komparators K5 ab, welches fortlaufend abwechselt zwischen einem Ausgangswert U5 und einem Testwert U6 (Figur 21). Der Ausgangswert U5 und der Testwert U6 bilden die Grenzen eines Toleranzbereichs für die Referenzspannung Uref5. Der Modulator MD5 ist so eingerichtet, dass der Ausgangswert U5 gleich dem Fremdsignal UF ist und die Schaltschwelle Uref5 zumindest zu einem Anfangszeitpunkt t0 innerhalb des Toleranzbereichs liegt. Zum Anfangszeitpunkt t0 weist der Testwert U6 den Wert U6₀ auf. Das Fremdsignal UF weist zum Anfangszeitpunkt t0 den Sollwert UFsoll auf (Figur 21).

Der Modulator MD5 erzeugt das Modulatorsignal MS5 dadurch, dass er das Fremdsignal UF in fortlaufender zeitlicher Abfolge abwechselnd unverändert als Ausgangswert U5 an den Signaleingang K5E1 des Schaltgebers K5 abgibt, so dass UF=U5 gilt, und das Fremdsignal UF auf den Testwert U6 abgeschwächt an den Signaleingang K5E1 des Schaltgebers K5 abgibt, so dass der Testwert U6 durch das abgeschwächte Fremdsignal gegeben ist und U6<UF gilt. Bevorzugt schwächt der Modulator MD5 das Fremdsignal U5 zur Erzeugung des Testwertes U6 um einen vorgegebenen Betrag ab, so dass die Differenz UF-U6 konstant ist. Gemäß einer anderen Ausführungsform schwächt der Modulator MD5 das Fremdsignal UF zur Erzeugung des Testwertes U6 auf einen bestimmten Bruchteil ab. Bevorzugt erzeugt der Modulator MD5 den Testwert U6 stets so, dass bei Zunahme des Fremdsignals UF auch der Testwert U6 zunimmt, und bei Abnahme des Fremdsignals UF auch der Testwert U6 abnimmt.

Der Komparator K5 gibt über eine Leitung L15 ein Schaltausgangssignal S5 ab, welches einen ersten Wert W5 annimmt, falls das Modulatorsignal MS5 größer ist als die Schaltschwelle Uref5, und andernfalls einen zweiten Wert W6 annimmt.

Daher pulsiert das Ausgangssignal S5 dann im Takt des Modulatorsignals MS5 zwischen dem ersten und dem zweiten Wert W5,W6, wenn die Schaltschwelle Uref5 im Toleranzbereich liegt und somit das Signal UF um höchstens eine vorgegebene Toleranz vom Sollwert UFsoll abweicht (Figur 22). Andernfalls pulsiert das Ausgangssignal S5 nicht.

Die Auswerteeinrichtung A5 überwacht das Ausgangssignal S5 auf Pulsation und löst ein Alarmsignal AS5 aus, wenn das Ausgangssignal S5 für mindestens eine vorgegebene Prüfzeitspanne dt' nicht pulsiert. Das Alarmsignal AS5 zeigt also an, dass der Toleranzbereich die Schaltschwelle Uref5 nicht mehr einschließt und somit das elektrische Signal U5 um mehr als die vorgegebene Toleranz vom Sollwert U5soll abweicht.

Zum Zeitpunkt t0 befindet sich das auf Drift zu überwachende Fremdsignal UF auf dem Sollwert UFsoll und der Testwert U6 auf dem Wert U6₀. Die Referenzspannung Uref5 in der Umgebung des Zeitpunktes t0 liegt zwischen diesen Werten. Daher pulsiert das Schaltausgangssignal S5 in der Umgebung des Zeitpunktes t0 (Figur 22).

Im Beispiel von Figur 21 wächst das zu überwachende Fremdsignal UF und damit auch die Obergrenze U5 des Toleranzbereichs jedoch auf Grund einer Drift mit der Zeit an. Die Folge davon ist, dass auch der Testwert U6 ansteigt, was bedeutet, dass sich in Figur 21 der Toleranzbereich mit der Zeit nach oben verschiebt, d.h. er wird erfindungsgemäß der Drift des zu überwachenden Signals UF nachgeführt.

Zu einem Zeitpunkt t13 übersteigt der Testwert U6 den Schwellwert Uref5, so dass die Pulsation des Schaltausgangssignals S5 aufhört. Die Auswerteschaltung A5 überwacht das Schaltausgangssignal S5 auf Pulsation und löst ein Alarmsignal AS5 aus, wenn das Schaltausgangssignal S5 für eine Prüfzeitspanne dt' nicht pulsiert. Zu einem Zeitpunkt t14 = t13+dt' wird daher im Beispiel der Figuren 20 bis 22 das Alarmsignal AS5 ausgelöst, welches anzeigt, dass sich das zu überwachende Signal UF um mehr als einen bestimmten Betrag von seinem Sollwert UFsoll entfernt hat.

Erfindungsgemäß wird also mit der Schaltung von Figur 20 der Toleranzbereich dem auf Drift zu überwachenden Signal UF nachgeführt, wobei die Schaltschwelle Uref5 konstant gehalten wird, so dass diese nicht mehr im Toleranzbereich liegt und somit das Alarmsignal ausgelöst wird, wenn das Signal UF um mehr als einen bestimmten Betrag vom Sollwert UFsoll abweicht.

Die gestrichelten Linien in Figur 21 bilden eine Einhüllende des rechteckförmig pulsierenden Modulatorsignals MS5, welche der Drift des Fremdsignals UF folgt bzw. dieser erfindungsgemäß nachgeführt wird. Die zeitliche Abfolge der Pulse des Modulatorsignals ist schnell im Vergleich zur Änderungsgeschwindigkeit des Fremdsignals UF.

In völlig entsprechender Weise wird das Fremdsignal UF erfindungsgemäß mittels der Schaltung von Figur 20 nicht nur, wie in den Figur 21 und 22 veranschaulicht, auf Zunahme (Aufwärtsdrift), sondern auch auf Abnahme (Abwärtsdrift) überwacht, denn sobald das Fremdsignal UF den Referenzwert Uref5 unterschreitet (Figur 21), hört die Pulsation des Schaltausgangssignals S5 ebenfalls auf.

Völlig entsprechend lässt sich anstelle des Spannungssignals UF ein Stromsignal auf Drift überwachen. Eine Möglichkeit hierzu besteht darin, das Stromsignal in ein Spannungssignal umzuwandeln mit diesem ebenso zu verfahren wie unter Bezug auf die Figuren 20 bis 22 erläutert wurde. Eine andere Möglichkeit besteht darin, den Komparator K5 durch einen Schaltgeber mit Stromschaltschwelle zu ersetzen (z.B. Optokoppler), und den Modulator MD5 durch einen solchen zu ersetzen, welcher, anstatt abwechselnd den Spannungs-Ausgangswert U5 und den Spannungs-Testwert U6 an den Schaltgeber abzugeben, abwechselnd einen Strom-Ausgangswert und einen Strom-Testwert an den Schaltgebers abgibt, wobei dessen Schaltschwelle zumindest zum Anfangszeitpunkt t0 zwischen dem Strom-Ausgangswert und dem Strom-Testwert liegt. Die Referenzspannung Uref5 und die Leitung L12 können in diesem Fall entfallen, wenn der Schaltgeber eine intrinsische Schaltschwelle aufweist, was z.B. bei einem Optokoppler gegeben ist. Der Modulator kann das zu überwachende Stromsignal in fortlaufender zeitlicher Abfolge abwechselnd unverändert an den Signaleingang des Schaltgebers abgeben, so dass der Strom-Ausgangswert durch das unveränderte Stromsignal gegeben ist, und abgeschwächt an den Signaleingang des Schaltgebers abgeben, so dass der Strom-Testwert durch das abgeschwächte Stromsignal gegeben ist. Bevorzugt erzeugt der Modulator den Strom-Testwert stets so, dass bei Zunahme des Stromsignals auch der Strom-Testwert zunimmt, und bei Abnahme des Stromsignals auch der Strom-Testwert abnimmt.

**Liste der Bezugszeichen:**

| | |
|---|---|
| 1 | Klemme |
| A, A5 | Auswerteeinrichtungen |
| AS | Alarmsignal |
| AWS | Auswerteschaltung |
| B | Bus |
| dt, dt', dT | Prüfzeitspannen |
| I1, I2 | Strom-Ausgangswert bzw. Strom-Testwert |
| IF | Interface |
| Iruhe, Isoll | Strom-Ruhesignal bzw. Soll-Stromwert |
| K, K5 | Komparatoren |
| KA | Schaltausgang von K |
| KE1 | Signaleingang von K |
| KE2 | Referenzeingang von K |
| K5A | Schaltausgang von K5 |
| K5E1 | Signaleingang von K5 |
| K5E2 | Referenzeingang von K5 |
| L1-L16 | Leitungen |
| MA | Master |
| MD, MD', MD", MD5 | Modulatoren |
| MS, MS',MS",MS5 | Modulatorsignale |
| OK,W | Optokoppler |
| OKE, OKA | Signaleingang von OK bzw. Schaltausgang von OK |
| OSQ | Offset-Spannungsquelle |
| R | Rechtecksignal |
| R1, R2 | Widerstände |
| SAO | Schaltungsanordnung |
| SB | Strombegrenzer |
| SCH | steuerbarer Schalter |
| SL1,SL2, SL' | Slaves |
| ST | Steuerleitung |
| Swl | Schaltschwelle von OK |
| SwU | Schaltschwelle von K |
| S1, S1' | Quellensignale |
| S3,S3',S3",S5 | Schaltausgangssignale |
| T | Taktgeber |
| T1,T2 | Transistoren |
| t0 | Anfangszeitpunkt |
| t1-t14, t3',t5',t7' | Zeitpunkte |
| Uref,Uref5 | Referenzspannungen |
| Uruhe | Spannungs-Ruhesignal |
| Usmin | Offset-Spannung |
| Usoll, Usminsoll,U5soll | Soll-Spannungswerte |
| U1,U3,U5 | Spannungs-Ausgangswerte |
| U2,U4,U6 | Spannungs-Testwerte |
| U6₀ | Wert von U6 zum Zeitpunkt t0 |
| W | Wandler |
| W1 | erster Wert von S3, S3' |
| W2 | zweiter Wert von S3, S3' |
| W3,W4 | Werte von ZMS |
| W5,W6 | Werte von S5 |
| ZA | Zusatz-Auswerteeinrichtung |
| ZAS | Zusatz-Alarmsignal |
| ZK | Zusatz-Schaltgeber |
| ZKA | Schaltausgang von ZK |
| ZKE1 | Signaleingang von ZK |
| ZKE2 | Referenzeingang von ZK |
| ZMD | Zusatz-Modulator |
| ZMS | Zusatz-Modulatorsignal |
| ZS3 | Zusatz-Schaltausgangssignal |

## Patentansprüche

1. Verfahren zum Überwachen, ob die Schaltschwelle (SwU,SwI,Usmin,Uref5) eines Schaltgebers (K,K5,OK,W,ZK), insbesondere eines Komparators (K,K5,ZK), innerhalb eines vorgegebenen Toleranzbereichs liegt oder nicht, wobei der Schaltgeber (K,K5,OK,W,ZK)
- einen Signaleingang (KE1,OKE,ZKE1), an welchem ein Eingangssignal anliegt, sowie einen Schaltausgang (KA,OKA,ZKA) aufweist
- und über den Schaltausgang (KA,OKA,ZKA) ein Schaltausgangssignal (S3,S3',S3",S5,ZS3) abgibt, welches einen ersten Wert (W1,W3,W5) annimmt, falls das Eingangssignal größer ist als die Schaltschwelle (SwU,SwI,Usmin, Uref5), und andernfalls einen zweiten Wert (W2,W4,W5) annimmt,
**dadurch gekennzeichnet, dass**
a) als Eingangssignal ein von einem Modulator (MD,MD',MD",MD5) erzeugtes Modulatorsignal (MS,MS',MS",ZMS,MS5) verwendet wird, welches sich fortlaufend oder zyklisch ändert zwischen einem Ausgangswert (U1,I1,U3,U5), welcher die obere Grenze (U1,I1,U3,U5) des Toleranzbereichs vorgibt, und einem Testwert (U2,I2,U4,U6), welcher kleiner ist als der Ausgangswert (U1,I1,U3,U5) und die untere Grenze (U2,I2,U4,U6) des Toleranzbereichs vorgibt,
so dass das Schaltausgangssignal (S3,S3',S3",ZS3) dann im Takt des Modulatorsignals (MS,MS',ZMS,MS5) zwischen dem ersten und dem zweiten Wert (W1, W3,W5,W2,W4,W6) pulsiert, wenn die Schaltschwelle (SwU,SWI,Usmin,Uref5) des Schaltgebers (K,K5,OK,W,ZK) im Toleranzbereich liegt, und andernfalls nicht pulsiert,
b) und das Schaltausgangssignal (S3,S3',S3",S5,ZS3) mittels einer Auswerteeinrichtung (A,AWS,MA,ZA) auf Pulsation überwacht und ein Alarmsignal (AS,ZAS) ausgelöst wird, wenn das Schaltausgangssignal (S3,S3',S3",S5,ZS3) für mindestens eine vorgegebene Prüfzeitspanne (dt,dT,dt') nicht pulsiert.

2. Verfahren nach Anspruch 1, **dadurch gekennzeichnet, dass**
der Ausgangswert (U1,I1,U3) und der Testwert (U2,I2,U4) jeweils konstant oder jeweils im zeitlichen Mittel konstant gehalten werden, so dass das Alarmsignal (AS,ZAS) eine Drift der Schaltschwelle (SwU,SwI,Usmin,Uref5) nach außerhalb des Toleranzbereichs anzeigt.

3. Verfahren nach Anspruch 2, **dadurch gekennzeichnet, dass**
der Schaltgeber (K,K5,ZK) ein Komparator (K,K5,ZK) mit einem Referenzeingang (KE2,K5E2,ZKE2) ist und die Schaltschwelle durch eine am Referenzeingang (KE2,K5E2,ZKE2) anliegende Referenzspannung vorgegeben wird, so dass eine Drift der Referenzspannung eine Drift der Schaltschwelle nach sich zieht und daher das Alarmsignal (AS,ZAS) eine Drift der Referenzspannung um mehr als einen bestimmten Toleranzbetrag anzeigt.

4. Verfahren nach Anspruch 1, **dadurch gekennzeichnet, dass**
- die Schaltschwelle (Uref5) konstant oder im zeitlichen Mittel konstant gehalten wird,
- der Modulator (MD5) einen Eingang aufweist, an welchem ein Fremdsignal (UF) anliegt,
- und bei Ansteigen des Fremdsignals (UF) wenigstens der Testwert (U6) und damit die untere Grenze (U6) des Toleranzbereichs angehoben wird,
so dass spätestens dann, wenn das Fremdsignal (UF) um mehr als einen bestimmten Betrag angestiegen ist, die Schaltschwelle (Uref5) unterhalb des Toleranzbereichs liegt und somit das Alarmsignal (AS) ausgelöst wird.

5. Verfahren nach Anspruch 4, **dadurch gekennzeichnet, dass**
- entweder das Fremdsignal und der Testwert miteinander identisch sind,
- oder der Testwert (U6) so aus dem Fremdsignal (UF) abgeleitet wird, dass bei Zunahme des Fremdsignals (UF) auch der Testwert (U6) zunimmt und bei Abnahme des Fremdsignals (UF) auch der Testwert (U6) abnimmt.

6. Verfahren nach einem der Ansprüche 1, 4 oder 5, **dadurch gekennzeichnet, dass**
- die Schaltschwelle (Uref5) konstant oder im zeitlichen Mittel konstant gehalten wird,
- der Modulator (MD5) einen Eingang aufweist, an welchem ein Fremdsignal (UF) anliegt,
- und bei Abfallen des Fremdsignals (UF) wenigstens der Ausgangswert (U5) und damit die obere Grenze (U5) des Toleranzbereichs abgesenkt wird,
so dass spätestens dann, wenn das Fremdsignal (UF) um mehr als einen bestimmten Betrag abgefallen ist, die Schaltschwelle (Uref5) oberhalb des Toleranzbereichs liegt und somit das Alarmsignal (AS) ausgelöst wird.

7. Verfahren nach Anspruch 6, **dadurch gekennzeichnet, dass**
- entweder das Fremdsignal (UF) und der Ausgangswert (U5) miteinander identisch sind,
- oder der Ausgangswert (U5) so aus dem Fremdsignal (UF) abgeleitet wird, dass bei Zunahme des Fremdsignals (UF) auch der Ausgangswert (U5) zunimmt und bei Abnahme des Fremdsignals (UF) auch der Ausgangswert (U5) abnimmt.

8. Verfahren nach einem der Ansprüche 4 bis 7, **dadurch gekennzeichnet,**
**dass** für das Fremdsignal (UF) ein Fremdsignal-Sollwert (UFsoll) vorgegeben wird, welcher größer ist als die Schaltschwelle (Uref5), wobei
entweder
- der Ausgangswert (U5) wenigstens zu einem Anfangszeitpunkt (t0) gleich dem Fremdsignal-Sollwert (UFsoll) und größer als die Schaltschwelle (Uref5) ist,
- und der Testwert (U6) wenigstens zum Anfangszeitpunkt (t0) kleiner ist als die Schaltschwelle (Uref5),
oder
- der Testwert (U6) wenigstens zu einem Anfangszeitpunkt (t0) gleich dem Fremdsignal-Sollwert (UFsoll) und kleiner als die Schaltschwelle (Uref5) ist,
- und der Ausgangswert (U5) wenigstens zum Anfangszeitpunkt (t0) größer ist als die Schaltschwelle (Uref5),
so dass Schaltschwelle (Uref5) zumindest zum Anfangszeitpunkt (t0) innerhalb des Toleranzbereichs liegt.

9. Verfahren nach einem der vorigen Ansprüche, **dadurch gekennzeichnet, dass**
- die Differenz zwischen dem Ausgangswert (U1,U5) und dem Testwert (U2,U6) zeitlich konstant oder im zeitlichen Mittel konstant gehalten wird,
- oder die Differenz zwischen dem Ausgangswert (U1,U5) und dem Testwert (U2,U6) auf einen vorgegebenen Maximalwert begrenzt wird,
- oder der Quotient aus dem Ausgangswert (U1,U5) und dem Testwert (U2,U6) zeitlich konstant oder im zeitlichen Mittel konstant gehalten wird.

10. Verfahren nach einem der vorigen Ansprüche, **dadurch gekennzeichnet,**
**dass** als Schaltgeber
- ein Optokoppler (OK,W) oder ein Transistor oder ein elektronischer Schalter oder ein Differenzverstärker verwendet wird,
- oder ein Komparator (K) mit einem Referenzeingang (KE2) verwendet wird, an welchen zur Vorgabe der Schaltschwelle (Sw) eine Referenzspannung (Uref) angelegt wird.

11. Verfahren nach einem der Ansprüche 2 oder 3, **dadurch gekennzeichnet, dass** für die Schaltschwelle (SwU,Swl) ein Sollwert (Usoll,Isoll) vorgegeben wird, welcher
kleiner ist als der Ausgangswert (U1,11) und größer ist als der Testwert (U2,I2), wobei eine Signalquelle (S,S') verwendet wird, welche dem Modulator (MD,MD',MD") vorgeschaltet ist und wenigstens zeitweise
(i) ein Quellensignal (S1,S1') an den Modulator (MD,MD',MD") abgibt, welches größer ist als der Sollwert (Usoll,Isoll),
(ii) oder ein Quellensignal an den Modulator (MD,MD',MD") abgibt, welches kleiner ist als der Sollwert (Usoll,Isoll),
wobei das Modulatorsignal (S2,S2') vom Modulator (MD,MD',MD") nur dann an den Signaleingang (KE1,OKE) des Schaltgebers (K,OK,W) abgegeben wird, wenn der Modulator (MD,MD',MD") das Quellensignal (S1,S1') von der Signalquelle (S,S') erhält.

12. Verfahren nach Anspruch 1 oder nach einem der Ansprüche 4 bis 7,
**dadurch gekennzeichnet, dass** eine Signalquelle verwendet wird, welche dem Modulator (MD5) vorgeschaltet ist und ein Quellensignal an den Modulator (MD5) abgibt, welches gleich dem Ausgangswert (U5) oder zu diesem proportional ist, oder welches gleich dem Testwert (U6) oder zu diesem proportional ist.

13. Verfahren nach einem der Ansprüche 11 bis 12, **dadurch gekennzeichnet,**
**dass** das Modulatorsignal (S2) **dadurch** erzeugt wird, dass vom Modulator (MD,MD',MD") das Quellensignal (S1,S1')
- entweder in fortlaufender oder zyklischer zeitlicher Abfolge nacheinander oder abwechselnd unverändert an den Signaleingang (KE1,OKE) des Schaltgebers (K,OK,W) abgegeben wird, so dass der Ausgangswert (U1,I1) durch das unveränderte Quellensignal (S1,S1') gegeben ist, und abgeschwächt an den Signaleingang (KE1,OKE) des Schaltgebers (K,OK,W) abgegeben wird, so dass der Testwert (U2,I2) durch das abgeschwächte Quellensignal (S1,S1') gegeben ist,
- oder in fortlaufender oder zyklischer zeitlicher Abfolge nacheinander oder abwechselnd auf einen ersten Bruchteil abgeschwächt an den Signaleingang (KE1,OKE) des Schaltgebers (K,OK,W) abgegeben wird, so dass der Ausgangswert (U1,I1) durch das auf den ersten Bruchteil verringerte Quellensignal (S1,S1') gegeben ist, und auf einen zweiten Bruchteil abgeschwächt an den Signaleingang (KE1,OKE) des Schaltgebers (K,OK,W) abgegeben wird, so dass der Testwert (U2,I2) durch das auf den zweiten Bruchteil abgeschwächte Quellensignal (S1,S1') gegeben ist, wobei der erste Bruchteil größer ist als der zweite Bruchteil.

14. Verfahren nach einem der vorigen Ansprüche, **dadurch gekennzeichnet,**
**dass** der Schaltgeber (W) über eine Offset-Spannungsquelle (OSQ) an Masse angeschlossen ist, wobei die Offset-Spannungsquelle (OSQ) eine Offset-Spannung (Usmin) abgibt und hierdurch die Schaltschwelle des Schaltgebers (W) um die Offset-Spannung (Usmin) verschoben wird.

15. Verfahren nach Anspruch 14, **dadurch gekennzeichnet,**
**dass** die Offset-Spannung (Usmin) mit einem Verfahren gemäß einem der Ansprüche 1 bis 26 überwacht wird.

## Claims

1. A method for monitoring whether the switching threshold (SwU, Swl, U_{Smin}, U_{ref}5) of a switching transducer (K, K5, OK, W, ZK), especially of a comparator (K, K5, ZK), lies within a predefined tolerance range or not, whereby the switching transducer (K, K5, OK, W, ZK)
- has a signal input (KE1, OKE, ZKE1) at which an input signal is present, as well as a switching output (KA, OKA, ZKA)
- and, via the switching output (KA, OKA, ZKA), it emits a switching output signal (S3, S3', S3", S5, ZS3) that takes on a first value (W1, W3, W5) if the input signal is greater than the switching threshold (SwU, Swl, U_{Smin}, U_{ref}5), and otherwise, it takes on a second value (W2, W4, W6),
**characterized in that**
a) as the input signal, a modulator signal (MS, MS', MS", ZMS, MS5) generated by a modulator (MD, MD', MD", MD5) is used, said modulator signal changing continuously or cyclically between an output value (U1, I1, U3, U5) that specifies the upper limit (U1, I1, U3, U5) of the tolerance range and a test value (U2, I2, U4, U6) that is smaller than the output value (U1, I1, U3, U5) and that specifies the lower limit (U2, I2, U4, U6) of the tolerance range,
so that the switching output signal (S3, S3', S3", ZS3) then pulsates synchronously with the modulator signal (MS, MS', ZMS, MS5) between the first value (W1, W3, W5) and the second value (W2, W4, W6) when the switching threshold (SwU, Swl, U_{Smin}, U_{ref}5) of the switching transducer (K, K5, OK, W, ZK) lies within the tolerance range, and otherwise, it does not pulsate,
b) and the switching output signal (S3, S3', S3", S5, ZS3) is monitored for pulsation by means of an evaluation unit (A, AWS, MA, ZA), and an alarm signal (AS, ZAS) is triggered if the switching output signal (S3, S3', S3", S5, ZS3) does not pulsate for at least a predefined test time period (dt, dT, dt').

2. The method according to Claim 1, **characterized in that** the output value (U1, I1, U3) and the test value (U2, I2, U4) are each kept constant or else each kept constant on the average over time, so that the alarm signal (AS, ZAS) indicates a drift of the switching threshold (SwU, Swl, U_{Smin}, U_{ref}5) to outside of the tolerance range.

3. The method according to Claim 2, **characterized in that** the switching transducer (K, K5, ZK) is a comparator (K, K5, ZK) with a reference input (KE2, K5E2, ZKE2), and the switching threshold is predefined by a reference voltage present at the reference input (KE2, K5E2, ZKE2), so that a drift of the reference voltage brings about a drift of the switching threshold and therefore the alarm signal (AS, ZAS) indicates a drift of the reference voltage by more than a certain tolerance amount.

4. The method according to Claim 1, **characterized in that**
- the switching threshold (U_{ref}5) is kept constant or else kept constant on the average over time,
- the modulator (MD5) has an input at which an external signal (UF) is present,
- and, when the external signal (UF) rises, at least the test value (U6) and thus the lower limit (U6) of the tolerance range are raised,
so that, at the latest when the external signal (UF) has risen by more than a certain amount, the switching threshold (U_{ref}5) lies below the tolerance range and thus the alarm signal (AS) is triggered.

5. The method according to Claim 4, **characterized in that**
- either the external signal and the test value are identical to each other,
- or the test value (U6) is derived from the external signal (UF) in such a way that, when the external signal (UF) increases, the test value (U6) also increases, and when the external signal (UF) decreases, the test value (U6) also decreases.

6. The method according to one of Claims 1, 4 or 5, **characterized in that**
- the switching threshold (U_{ref}5) is kept constant or else kept constant on the average over time,
- the modulator (MD5) has an input at which an external signal (UF) is present,
- and, when the external signal (UF) drops, at least the output value (U5) and thus the upper limit (U5) of the tolerance range are lowered,
so that, at the latest when the external signal (UF) has dropped by more than a certain amount, the switching threshold (U_{ref}5) lies above the tolerance range and thus the alarm signal (AS) is triggered.

7. The method according to Claim 6, **characterized in that**
- either the external signal (UF) and the output value (U5) are identical to each other,
- or the output value (U5) is derived from the external signal (UF) in such a way that, when the external signal (UF) increases, the output value (U5) also increases, and when the external signal (UF) decreases, the output value (U5) also decreases.

8. The method according to one of Claims 4 to 7, **characterized in that** an external signal target value (UF_{target}) is predefined for the external signal (UF), said external signal target value being greater than the switching threshold (U_{ref}5), whereby
either
- the output value (U5), at least at a starting point in time (t0), is equal to the external signal target value (UF_{target}) and greater than the switching threshold (U_{ref}5),
- and the test value (U6), at least at the starting point in time(t0), is smaller than the switching threshold (U_{ref}5),
or
- the test value (U6), at least at a starting point in time(t0), is equal to the external signal target value (UF_{target}) and smaller than the switching threshold (U_{ref}5),
- and the output value (U5), at least at the starting point in time(t0), is greater than the switching threshold (U_{ref}5),
so that the switching threshold (U_{ref}5), at least at the starting point in time(t0), lies within the tolerance range

9. The method according to one of the preceding claims, **characterized in that**
- the difference between the output value (U1, U5) and the test value (U2, U6) is kept constant over time or else kept constant on the average over time,
- or the difference between the output value (U1, U5) and the test value (U2, U6) is limited to a predefined maximum value,
- or the quotient of the output value (U1, U5) and the test value (U2, U6) is kept constant over time or else it is kept constant on the average over time.

10. The method according to one of the preceding claims, **characterized in that**
- an optocoupler (OK, W) or a transistor or an electronic switch or a difference amplifier
- or else a comparator (K) with a reference input (KE2) at which a reference voltage (U_{ref}) is present in order to specify the switching threshold (Sw)
is used as the switching transducer.

11. The method according to Claim 2 or 3, **characterized in that** a target value (U_{target}, I_{target}) is predefined for the switching threshold (SwU, SwI), said target value being smaller than the output value (U1, I1) and greater than the test value (U2, I2), whereby a signal source (S, S') is used that is upstream from the modulator (MD, MD', MD") and, at least at times,
(i) emits a source signal (S1, S1') to the modulator (MD, MD', MD"), said source signal being greater than the target value (U_{target}, I_{target}),
(ii) or emits a source signal to the modulator (MD, MD', MD"), said source signal being smaller than the target value (U_{target}, I_{target}),
whereby the modulator signal (S2, S2') is only emitted to the signal input (KE1, OKE) of the switching transducer (K, OK, W) by the modulator (MD, MD', MD") when said modulator receives the source signal (S1, S1') from the signal source (S, S').

12. The method according to Claim 1 or according to one of Claims 4 to 7, **characterized in that**
a signal source is used that is upstream from the modulator (MD5) and that emits a source signal to the modulator (MD5) that is equal or proportional to the output value (U5), or that is equal or proportional to the test value (U6).

13. The method according to one of Claims 11 to 12, **characterized in that**
the modulator signal (S2) is generated **in that**
- the source signal (S1, S1') is emitted by the modulator (MD, MD', MD") either in a continuous or cyclical time sequence consecutively or alternatingly in unchanged form to the signal input (KE1, OKE) of the switching transducer (K, OK, W), so that the output value (U1, I1) is specified by the unchanged source signal (S1, S1'), and the source signal (S1, S1') is emitted by the modulator (MD, MD', MD") in attenuated form to the signal input (KE1, OKE) of the switching transducer (K, OK, W), so that the test value (U2, I2) is specified by the attenuated source signal (S1, S1'),
- or, either in a continuous or cyclical time sequence consecutively or alternatingly, the source signal (S1, S1'), which has been attenuated to a first fraction, is emitted by the modulator (MD, MD', MD") to the signal input (KE1, OKE) of the switching transducer (K, OK, W), so that the output value (U1, I1) is specified by the source signal (S1, S1'), which has been reduced to the first fraction, and the source signal (S1, S1'), which has been attenuated to a second fraction, is emitted by the modulator (MD, MD', MD") to the signal input (KE1, OKE) of the switching transducer (K, OK, W), so that the test value (U2, I2), which has been attenuated to the second fraction, is specified by the source signal (S1, S1'), whereby the first fraction is greater than the second fraction.

14. The method according to one of the preceding claims, **characterized in that**
the switching transducer (W) can be connected to the ground via an offset voltage source (OSQ), whereby the offset voltage source (OSQ) emits an offset voltage (U_{Smin}) and, as a result, the switching threshold of the switching transducer (W) is shifted by the amount of the offset voltage (U_{Smin}).

15. The method according to Claim 26, **characterized in that** the offset voltage (U_{Smin}) is monitored by a method according to one of Claims 1 to 26 *[sic].*

## Revendications

1. Procédé pour vérifier si le seuil de commutation (SwU,SwI,Usmin,Uref5) d'un générateur de commutation (K,K5,OK,W,ZK), en particulier d'un comparateur (K,K5,ZK), se situe, ou non, dans une plage de tolérance prédéfinie, le générateur de commutation (K,K5,OK,W,ZK)
- présentant une entrée de signal (KE1,OKE,ZKE1) à laquelle un signal d'entrée est appliqué, ainsi qu'une sortie de commutation (KA,OK,ZKA)
- et émettant, via la sortie de commutation (KA,OK,ZKA), un signal de sortie de commutation (S3,S3',S3",S5,ZS3) qui revêt une première valeur si le signal d'entrée est plus haut que le seuil de commutation (SwU,SwI, Usmin,Uref5), ou revêt sinon une seconde valeur (W2,W4,W5),
**caractérisé en ce que**
a) le signal d'entrée utilisé est un signal de modulateur (MS,MS',MS", ZMS,MS5) généré par un modulateur (MD,MD'MD",MD5), lequel signal de modulateur se modifie de façon continue ou cyclique entre une valeur de départ (U1,I1,U3,U5) qui définit la limite supérieure (U1,I1,U3,U5) de la plage de tolérance et une valeur test (U2,I2,U4,U6) qui est plus petite que la valeur de départ (U1,I1,U3,U5) et définit la limite inférieure (U2,I2,U4,U6) de la plage de tolérance,
de sorte que le signal de sortie de commutation (S3,S3',S3",ZS3) a une pulsation en cadence avec le signal du modulateur (MS,MS',ZMS,MSS) entre la première et la deuxième valeur (W1,W3,W5,W2,W4,W6) lorsque le seuil de commutation (SwU,SwI,Usmin,Uref5) du générateur de commutation (K,K5,OK,W,ZK) se situe dans la plage de tolérance, et sinon, n'a pas de pulsation,
b) et le signal de sortie de commutation (S3,S3',S3",S5,ZS3) est surveillé quant à sa pulsation au moyen d'un dispositif d'analyse, et un signal d'alarme (AS,ZAS) est déclenché lorsque le signal de sortie de commutation (S3,S3',S3",S5,ZS3) n'a pas de pulsation pendant au moins un laps de temps de vérification (dt,dT,dt') prédéfini.

2. Procédé selon la revendication 1, **caractérisé en ce que**
la valeur de départ (U1,I1,U3) et la valeur test (U2,I2,U4) sont maintenues respectivement constantes ou sont maintenues respectivement constantes dans la moyenne temporelle, de sorte que le signal d'alarme (AS,ZAS) fait état d'une dérive du seuil de commutation (SwU,SwI,Usmin,Uref5) vers l'extérieur de la plage de tolérance.

3. Procédé selon la revendication 2, **caractérisé en ce que**
le générateur de commutation (K,K5,ZK) est un comparateur (K,K5,ZK) avec une entrée de référence (KE2,K5E2,ZKE2) et le seuil de commutation est prédéfini par une tension de référence appliquée à l'entrée de référence (KE2,K5E2,ZKE2), de sorte qu'une dérive de la tension de référence entraîne une dérive du seuil de commutation et que de ce fait, le signal d'alarme (AS,ZAS) fait état d'une dérive de la tension de référence supérieure à une valeur de tolérance déterminée.

4. Procédé selon la revendication 1, **caractérisé en ce que**
- le seuil de commutation (Uref5) est maintenu constant ou est maintenu constant dans la moyenne temporelle,
- le modulateur (MD5) présente une entrée, à laquelle est appliqué un signal étranger (UF),
- et lorsque le signal étranger (UF) augmente, tout au moins la valeur test (U6), et ainsi la limite inférieure (U6) de la plage de tolérance, s'élèvent,
de sorte que, au plus tard lorsque le signal étranger (UF) augmente de plus d'une valeur déterminée, le seuil de commutation (Uref5) se situe au-dessous de la plage de tolérance et de ce fait, le signal d'alarme (AS) est déclenché.

5. Procédé selon la revendication 4, **caractérisé en ce que**
- ou bien le signal étranger et la valeur test sont identiques l'un l'autre,
- ou bien la valeur test (U6) est dérivée du signal étranger (UF), de sorte que, lorsque le signal étranger (UF) augmente, la valeur test (U6) augmente aussi, et lorsque le signal étranger (UF) diminue, la valeur test (U6) diminue aussi.

6. Procédé selon l'une des revendications 1, 4 ou 5, **caractérisé en ce que**,
- le seuil de commutation (Uref5) est maintenu constant ou est maintenu constant dans la moyenne temporelle,
- le modulateur (MD5) présente une entrée à laquelle est appliqué un signal étranger (UF),
- et lorsque le signal étranger (UF) diminue, tout au moins la valeur de départ (U5), et ainsi la limite supérieure (U5) de la plage de tolérance, s'abaissent,
de sorte que, au plus tard lorsque le signal étranger (UF) décroît de plus d'une valeur déterminée, le seuil de commutation (Uref5) se situe au-dessus de la plage de tolérance et ainsi, le signal d'alarme (AS) est déclenché.

7. Procédé selon la revendication 6, **caractérisé en ce que**,
- ou bien le signal étranger (UF) et la valeur de départ (U5) sont identiques l'un l'autre,
- ou bien la valeur de départ (U5) est dérivée du signal étranger (UF), de sorte que, lorsque le signal étranger (UF) augmente, la valeur de départ (U5) augmente aussi, et lorsque le signal étranger (UF) diminue, la valeur de départ (U5) diminue aussi.

8. Procédé selon l'une des revendications 4 à 7, **caractérisé en ce que** une valeur de consigne du signal étranger (UFsoll) est prédéfinie pour le signal étranger (UF), laquelle est plus élevée que le seuil de commutation (Uref5) ou bien
- la valeur de départ (U5) étant, tout du moins à un point de départ dans le temps (t0), égale à la valeur de consigne du signal étranger (UFsoll) et supérieure au seuil de commutation (Uref5),
- et la valeur test (U6) étant, tout du moins à un point de départ dans le temps (t0), plus petite que le seuil de commutation (Uref5),
ou bien
- la valeur test (U6) étant, tout du moins à un point de départ dans le temps (t0), égale à la valeur de consigne du signal étranger (UFsoll) et inférieure au seuil de commutation (Uref5),
- et la valeur de départ (U5) étant, tout du moins au point de départ dans le temps (t0), supérieure au seuil de commutation (Uref5),
de sorte que le seuil de commutation (Uref5) se situe, tout du moins au point de départ dans le temps (t0), à l'intérieur de la plage de tolérance.

9. Procédé selon l'une des revendications précédentes, **caractérisé en ce que**
- la différence entre la valeur de départ (U1,U5) et la valeur test (U2,U6) est maintenue constante dans le temps ou est maintenue constante dans la moyenne temporelle,
- ou la différence entre la valeur de départ (U1,U5) et la valeur test (U2,U6) est limitée à une valeur maxima prédéfinie,
- ou le quotient de la valeur de départ (U1,U5) par la valeur test (U2,U6) est maintenu constant dans le temps ou est maintenu constant dans la moyenne temporelle.

10. Procédé selon l'une des revendications précédentes, **caractérisé en ce que**
- le générateur de commutation utilisé est un coupleur optique (OK,W) ou un transistor ou un commutateur électronique ou un amplificateur différenciel,
- ou un comparateur (K) avec une entrée de référence (KE2) à laquelle est appliquée une tension de référence (Uref) qui prédéfinit le seuil de commutation (Sw).

11. Procédé selon l'une des revendications 2 ou 3, **caractérisé en ce que** une valeur de consigne (Usoll,Isoll) est prédéfinie pour le seuil de commutation (SwU,SwI), laquelle est plus petite que la valeur de départ (U1,I1) et plus grande que la valeur test (U2,I2), une source de signal (S,S') étant utilisée, laquelle est connectée en amont du modulateur (MD,MD',MD") et, tout du moins temporairement,
(i) délivre au modulateur (MD,MD',MD") un signal de source (S1,S1') qui est plus grand que la valeur de consigne (Usoll,Isoll),
(ii) ou délivre au modulateur (MD,MD',MD") un signal de source qui est plus petit que la valeur de consigne (Usoll,Isoll),
le signal de modulateur (S2,S2') du modulateur (MD,MD',MD") n'étant émis à l'entrée de signal (KE1,OKE) du générateur de commutation (K,OK,W) que lorsque le modulateur (MD,MD',MD") reçoit le signal de source (S1,S1') de la source de signal (S,S').

12. Procédé selon la revendication 1, ou selon l'une des revendications 4 à 7, **caractérisé en ce que**
la source de signal utilisée est connectée en amont du modulateur (MD5) et délivre au modulateur (MD5) un signal de source qui est égal à la valeur de départ (U5) ou proportionnel à celle-ci, ou qui est égal à la valeur test (U6) ou proportionnel à celle-ci.

13. Procédé selon l'une des revendications 11 ou 12, **caractérisé en ce que** le signal de modulateur (S2) est généré du fait que le signal de source (S1,S1') du modulateur (MD,MD',MD")
- ou bien est émis en une séquence continue ou cyclique dans le temps, successivement ou en alternance, de façon inchangée à l'entrée de signal (KE1,OKE) du générateur de commutation (K,OK,W), de sorte que la valeur de départ (U1,I1) est donnée par le signal de source inchangé (S1,S1'), et est émis affaibli à l'entrée de signal (KE1,OKE) du générateur de commutation (K,OK,W), de sorte que la valeur test (U2,I2) est donnée par le signal de source affaibli (S1,S1'),
- ou bien est émis en une séquence continue ou cyclique dans le temps, successivement ou en alternance, affaibli à une première fraction, à l'entrée de signal (KE1,OKE) du commutateur de commutation (K,OK,W), de sorte que la valeur de départ (U1,I1) est donnée par le signal de source (S1,S1'), réduit à la première fraction, et est émis, affaibli à une deuxième fraction, à l'entrée de signal (KE1,OKE) du commutateur de commutation (K,OK,W), de sorte que la valeur test (U2,I2) est donnée par le signal de source (S1,S1') affaibli à une deuxième fraction, la première fraction étant plus grande que la deuxième fraction.

14. Procédé selon l'une des revendications précédentes, **caractérisé en ce que** le générateur de commutation (W) est relié à la masse via une source de tension offset (OSQ), la source de tension offset (OSQ) émettant une tension offset (Usmin) et le seuil de commutation du générateur de commutation (W) étant de ce fait décalé de la valeur de tension (Usmin).

15. Procédé selon la revendication 14, **caractérisé en ce que** la tension offset (Usmin) est surveillée avec un procédé selon l'une des revendications 1 à 13.
